# EUROPEAN PATENT APPLICATION

(11) **EP 4 488 756 A2**
(43) Date of publication of application: **08.01.2025**
(21) Application number: 24186459.4
(22) Date of filing: 04.07.2024
(51) Int. Cl.: G03F 7/028, G03F 7/032, G03F 7/033

(54) **RELIEF PRECURSORS WITH ENHANCED STABILITY**

(30) Priority: 06.07.2023 NL 2035286
(71) Applicant: XSYS Germany GmbH, 77731 Willstatt (DE)
(72) Inventor: Schlegel, Isabel, 76456 KUPPENHEIM (DE); Dannecker, Patrick-Kurt, 77731 WILLSTATT (DE)
(74) Representative: Arnold & Siedsma

(57) **Abstract**

The present invention is directed to relief precursors with an enhanced capacity to be developed into high performing relief structures, more in particular high quality relief structures such as printing plates. Thereto, it provides a photosensitive composition (PC) for forming a photosensitive layer of a relief precursor (RP), comprising particular stabilizers and binders. By including the stabilizer and binder as described herein, it was found that the stability of the melt of the photosensitive composition during production, e.g. production by extrusion, could be enhanced significantly. Surprisingly, such enhanced stability could be achieved without or with minimal undesired impact on the resulting printing performance and/or imaging characteristics of the reliefs formed by developing the relief precursors.

## Description

The present invention relates to relief precursors with enhanced stability during extrusion without negative impact on the photochemical properties. By having enhanced extrusion stability, the development of the relief precursor and final characteristics of the relief formed with the relief precursor can be improved.

### BACKGROUND

Relief precursors such as printing plate precursors (e.g. printing blankets or sleeves) can be used to create a relief with relief structures. The relief (e.g. a cliché) can be used to press ink onto a substrate. Generally, the relief precursors are made of several layers. A backing layer, also known as a carrier layer is used for mechanical stability. A photosensitive layer is placed thereon and is selectively cured (e.g. by exposure or heat) in order to create cured portions within the photosensitive layer. The uncured portions are then removed (e.g. by washing them away) so that the cured portions are left behind and to form relief structures. This process is called developing of the relief precursor.

Before or during the developing of the precursor however, some unintentional pre-curing may occur, e.g. due to the heating of the precursor during production, upon development and/or during prolonged storage.

Unintentional curing can drastically influence the production process or performance of the final relief formed with the precursor. Namely, the production of the precursor is typically performed by an extrusion process, in which a thermoplastic elastomer e.g. a block copolymer is melted and other solid or liquid components are added to the melt within an extrusion line. To homogenize the mixture, the extrusion line may contain kneading elements. However, kneading with such kneading elements can result in mechanical and thermal stress in the rubber mixture, which can result in unintended gel formation.

Therefore, to avoid or minimize such gel formation, a stabilizer can be added to the mixture in order to prevent unintentional pre-curing, for example a thermal polymerization inhibitor can be added. However, conventional stabilizers may also influence the intentional curing process during the development of the relief precursors. As a result, convention stabilizers may influence performing characteristics of relief structures, e.g. the creation of fine dots. Moreover, conventional stabilizers might not be sufficiently efficient in preventing gel formation due to mechanical and thermal stress.

In order to generate a relief, which might be used as printing plate, the relief structure can be formed by exposure of a relief precursor to electromagnetic radiation through a mask, which carries the image information. Due to the exposure to radiation, the exposed portions of the relief precursor are cured and become insoluble or not meltable. In a developing step, the soluble or meltable portions of the relief precursor can be removed so that the required relief is formed. In the exposure step the stabilizers should not interfere with the curing reactions. Furthermore, the compositions with the stabilizers should preferably deliver short exposure times and good resolution with enhanced accuracy of the formed relief close to the target structure. Accordingly, the present inventors have recognized that there is a need for an improved binder-stabilizer system, in which the binder is sufficiently resistant towards unintended polymerization and formation of gel particles due to mechanical and thermal stress and preferably without impacting the desired performance of the relief structure.

### SUMMARY OF THE INVENTION

It is an object of embodiments of the invention to provide relief precursors with an enhanced capacity to be developed into high performing relief structures, more in particular high quality relief structures such as printing plates, even more in particular relief precursors for flexographic printing plates.

Thereto, embodiments of the invention provide a photosensitive composition (PC) for forming a photosensitive layer of a relief precursor (RP). The composition comprises:
a radical initiator (R) such as a photoinitiator, a photoinitiator system or a thermal initiator; and
optionally an ethylenically unsaturated compound (EC);
a stabilizer (S 1) for promoting extrusion stability, said stabilizer being a vitamin or a vitamin derivative; and
a binder (B), said binder being a thermoplastic elastomer block copolymer having
   - a first monomeric unit (Mu1) derived from a vinyl aromatic monomer and
   - a second monomeric unit (Mu2), said second monomer unit being derived from an ene-monomer and/or a diene-monomer; or combinations thereof.

Surprisingly it is found that when the vitamin stabilizer or the vitamin derivatives are combined with the thermoplastic elastomer block copolymer binders, a binder-stabilizer system is achieved having an improved the stability in the melt. This means a better resistance towards thermal and mechanical stress, e.g. during extrusion and production of the relief precursor.

By including the stabilizer and binder as described herein, it was found that the stability of the melt of the photosensitive composition during production, e.g. production by extrusion, could be enhanced significantly. Surprisingly, such enhanced stability could be achieved without or with minimal undesired impact on the resulting printing performance and/or imaging characteristics of the reliefs formed by developing the relief precursors.

Additionally, it was found that by including the vitamin or a vitamin derivative as a stabilizer, both production-as well as exposure and developing performance of the photosensitive composition can improved. Namely, the functionalities of the initiator and thermoplastic elastomer block are better maintained and without or with minimal impact of the raised temperatures resulting from thermal and/or mechanical stress during extrusion. Furthermore, gel formation as a result of "unintentional pre-curing" during production (before the curing by exposure) can be avoided or minimized.

Unintentional pre-curing can be understood as an occurrence of curing reactions which are (already) initiated before exposure of the relief precursor (e.g. development with LED-exposure).

The unintentional pre-curing can have a negative influence on final printing characteristics such as final imaging characteristics like dot size, and target value.

Further aspects relate to a relief precursor (RP) comprising the photosensitive composition (PC) as described herein and a relief, e.g. printing plate, having relief structures (RS) formed by exposing and developing the relief precursor (RP). By including the composition having the stabilizer-binder system as described herein, the relief precursors are less susceptible to UV induced brittleness. Further, a suitable developing compatibility with high intensity LED exposure can be achieved. More so, due to the presence of a well-designed stabilizer, the exposure times during exposure can be kept consistent.

By including a vitamin or a vitamin derivative in the photosensitive composition, one can achieve relief precursors, e.g. printing plate precursors, with an enhanced stability towards oxidation. This way, the plates can stay stable for a prolonged period, e.g. during storage.

Further aspects relate to the methods of developing the relief precursors to form a relief. It was found that the vitamin or vitamin derivative stabilizers as described herein may stabilize the photosensitive composition towards unintended crosslinking without impacting the intended photopolymerization and curing. Therefore, the quality of the relief structure formed from the relief precursor with the photosensitive composition within the photosensitive layer of the relief precursor is improved. Reliefs can be formed from the relief precursors with improved relief structures thereon, e.g. smaller dots remain after development. In addition, the accuracy of the relief structures may be enhanced as the dot size can be closer to target value.

Further, to reduce the stickiness of the plate, after the developing step, the precursor might be further treated with UV-A and or UV-C irradiation. A side effect can be an increase in brittleness and sensitivity towards mechanical defects of the printing plate. Is was found, that the photosensitive composition as described herein can prevent UV-induced brittleness.

In an embodiment, the vitamin or vitamin derivative stabilizer (S1) has a predicted log octanol-water coefficient as calculated within EPI Suite v4.11 from Log Kow (WSKOW v 1.68 estimate) and wherein said predicted octanol-water coefficient (OWc) is higher than - 4, preferably higher than -2, more preferably higher than 0, even more preferably higher than 5, preferably about 6. By including a fine selection the predicted octanol-water coefficient of the vitamin or vitamin derivative stabilizer, it was found that the behavior thereof within thermoplastic elastomer binder system could be improved (e.g. an improved phase stabilization within an organic binder system such as a system with SBS and/or SIS binders). According to an embodiment, the predicted log octanol-water coefficient is in the range of -4.0 to 12.0 as calculated within EPI Suite v4.11 from Log Kow (WSKOW v 1.68 estimate), more preferably in the range of -2.0 to 11.0, even more preferably in the range of 0.0 to 10.0, even more preferably in the range of 1.0 to 8.0, such as a coefficient in the range of 2.0 to 6.5, more in particular such as in the range of 5.0 to 6,5. By having a carefully chosen Log Kow value (also described herein as the predicted log octanol-water coefficient), the compatibility with the other components in the composition can be improved benefitting an overall improved behavior and thermal stabilization during the extrusion of the composition to make the relief precursor of the printing plate. For derivatives and substances not within the preferred range, a phase separation within the relief precursor or migration to the surface might occur. Moreover, the block copolymer binder system itself is phase separated on a microscopic level. Sufficient stabilization is only achieved, when the stabilizer is present within those phases, that are particularly susceptible to unintentional precuring, strongly depending on the overall formulation, binder system, and monomer composition.

The photosensitive composition may have a further second stabilizer (S2) chosen from one of the following classes: phenolic, phenolic and acrylate, thioether, hindered amine, phenolic and amine, amine, thioether amine, a multifunctional amine and acrylate. Surprisingly, the vitamin or a vitamin derivative, e.g. ascorbyl palmitate, may improve stabilization of the second stabilizer in a synergistic manner.

In an embodiment, the vitamin or vitamin derivative stabilizer (S1) has a molecular weight in the range of 50 - 800 g/mol, preferably 50 - 600 g/mol, more preferably 100 - 490 g/mol, even more preferably 120 - 480 g/mol, most preferably 200 - 430 g/mol.

In an embodiment, the vitamin or vitamin derivative stabilizer (S1) is chosen from vitamins A, C, and E or derivatives thereof, preferably C and E, more preferably C as the radical scavenging properties thereof may improve extrusion stability.

In an embodiment, the vitamin or vitamin derivative stabilizer (S1) is a hydroxy tetronic acid (HTAD) derivative. The hydroxy tetronic acid can be included in the stabilizer as a substructure and can provide stabilization of sensitive components by capturing (uncontrolled) free radicals thereby avoiding or minimize the impact thereof on the sensitive components in the composition.

In an embodiment, the vitamin or vitamin derivative stabilizer (S1) is a vitamin C derivative, preferably an ascorbic acid ester, even more preferably a fatty acid ester of ascorbic acid, more in particular an ascorbyl palmitate (AP).

In an embodiment, the vitamin or vitamin derivative stabilizer (S1) is present in a concentration of 0.1 to 10 wt.%, preferably 0.1 to 8 wt%, more preferably 0.2 to 6 wt%, even more preferably 0.5 to 2% based on the total weight of the photosensitive composition (PC). In this way, a balance between stabilization behavior, e.g. preventing unintended curing, and the crosslinking capabilities (intended curing) of the photosensitive composition can be achieved. Hence, gel formation during production processes, e.g. extrusion, can be avoided and/or minimized without having to make a compromise on final printing properties of the relief formed with the photosensitive composition.

In an embodiment, the binder has a total styrene content in the range of 3 - 50 %, preferably 8 - 38 %, more preferably 10 - 30 %, most preferably 15 - 30 %.

In an embodiment, the binder (B) is chosen from a styrene-butadiene-styrene (SBS) triblock copolymer and/or a styrene-isoprene-styrene (SIS) triblock copolymer.

In an embodiment, the binder (B) is chosen from an SBS triblock copolymer
having a styrene content in the range of 8 - 48 %, preferably 13 - 43 %, more preferably 18 - 38 %, e.g. around 28 %.

In an embodiment, the binder (B) is a SIS triblock copolymer having a styrene content
in the range of 3 - 27 %, preferably 5 - 25 %, e.g. around 15 %.

In an embodiment, the binder (B) is a diblock copolymer or is a triblock copolymer with a diblock fraction in the range of 5 - 50 %, preferably 5 - 30 %, more preferably 8 - 28 %, even more preferably 10 - 24 %, e.g. around 17 % - 19%.

It was found that the binders (B) as described above had a good compatibility with the vitamin or vitamin derivatives stabilizer. A good binder-stabilizer system could be included in the composition such that the relief precursor could be produced while keeping a great melt stability and without or with minimal undesired impact on the developing performance such as exposure times and final printing performance such as resolution.

In an embodiment, the vitamin or vitamin derivative stabilizer (S1) is ascorbyl palmitate (AP) and the binder (B) is a SB diblock and/or SBS triblock copolymer as such combination may aid in exceptional processing behavior, in particular during extrusion without or minimal impact on final printing performance.

In an embodiment, the vitamin or vitamin derivative stabilizer (S1) is ascorbyl palmitate (AP) and the binder (B) is a SI diblock and/or SIS triblock copolymer as such combination may aid in exceptional processing behavior, in particular during extrusion without or minimal impact on final printing performance.

In an embodiment, the composition further comprises a bio-based plasticizer (P), preferably a vegetable oil, a fatty acid and/or a fatty acid ester of mono and polyfunctional alcohols. Preferably, the plasticizer is characterized by a UV transmission at 365 nm of a solution of 33 wt% plasticizer in n-hexane of higher than 1%, preferably higher than 10%, more preferably higher than 50%, even more preferably higher than 60%. Preferably; the plasticizer has an iodine value according to ISO 3961:2018 below 200, preferably below 150 so that a high quality can be achieved. In an embodiment, the plasticizer is characterized by a Gardner color lower than 7 according to ISO 4630:2015. Said plasticizers can be used to maintain flexibility at varying temperature ranges which is beneficial when performing high volume production processes such as extrusion production. More preferably, the UV transmission is higher than 15%, preferably higher than 25%, more preferably higher than 50%, even more preferably higher than 60%. The bio-based plasticizer is preferably present within the composition in an amount of at least 11 wt %, preferably at least 14 wt %, even more preferably at least 16 wt % as based on the total weight of the components within the photosensitive composition. The bio-based plasticizer may further achieve several benefits as they contribute to the flexibility, flowability, thermal stability, impact resistance of the relief precursor and/or the printing plate. The bio-based plasticizer may be present in an amount between 11 - 60 wt %, preferably between 12 - 55 wt %. By including the plasticizer as described, the developing times could be shortened and energy savings could be achieved. Additionally, the use of the bio-based plasticizers was found to promote final printing performance. Preferably, the bio-based plasticizer is chosen from rapeseed oil, sunflower oil, palm kernel oil, soybean oil, rapeseed oil (canola oil), sunflower oil, soybean oil, palm oil, palm kernel oil, coconut oil, medium-chain triglycerides (MCT), linseed oil, safflower oil, corn oil and/or cotton seed oil as long as the UV transmission thereof at 365 nm of a solution of 33 wt% plasticizer in n-hexane is of higher than 15%. More preferably, the bio-based plasticizer is preferably chosen from sunflower oil or rapeseed oil (also known as canola oil).

A further aspect relates to a method to produce a relief precursor (RP), comprising the steps of:
- extruding the photosensitive composition (PC) as described herein to form an extruded photosensitive layer;
- applying the extruded layer on a dimensionally stable support (L1).

It has been found that the relief precursors can be produced in high volumes by deploying an extrusion process. Particularly due to the incorporation of the stabilizers as described herein, the extrusion stability of the photosensitive composition can be improved and gel formation during production can be avoided. Understandably, the photosensitive composition within the relief precursor may have any of the features as described in connection to the photosensitive composition. Surprisingly good performance was achieved by having the combination of stabilizer and binders as described herein.

A further aspect relates to the relief precursor (RP) for being developed into a relief (RS) comprising:
- a dimensionally stable support (L1), such as a support layer like a PET layer.
- a photosensitive layer (L2) comprising the photosensitive composition as described herein.

The dimensionally stable support may also be referred to as a carrier layer and can be made from a material chosen from the group consisting of aluminum, steel, a polymer, and synthetic composites.

In an embodiment, the relief (RS) developed from the relief precursor (RP) serves as a printing sleeve or printing blanket.

A further aspect relates to the inventive uses, said uses including:
The use of the vitamin or vitamin derivative, preferably ascorbyl palmitate (AP), to improve extrusion stability of a mixture. Preferably vitamins that are including hydroxy tetronic acid (HTAD) as a substructure.

The use of a stabilizer (S1) being a vitamin or vitamin derivative to enhance the thermal stabilization of a second stabilizer (S2) being a thermal stabilizer. Preferably, wherein the second stabilizer (S2) is chosen from one of the following classes: phenolic, phenolic and acrylate, thioether, hindered amine, phenolic and amine, amine, thioether amine, a multifunctional amine and acrylate. The second stabilizer (S2) can be butylated hydroxy toluene (BHT).

According to an aspect, there is provided a vitamin derivative for stabilizing a thermally and/or radiation sensitive components, such as components within a photosensitive layer of a relief precursor for forming a relief such as a printing plate (also referred to as a cliché). Thereto, the vitamin derivative is an ascorbic acid derivative (AAD) for stabilizing a thermally and/or radiation sensitive components, in particular said ascorbic acid derivative (AAD) being a carbamate derivative represented by formula I or stereo isomeric forms thereof, wherein formula I represents: 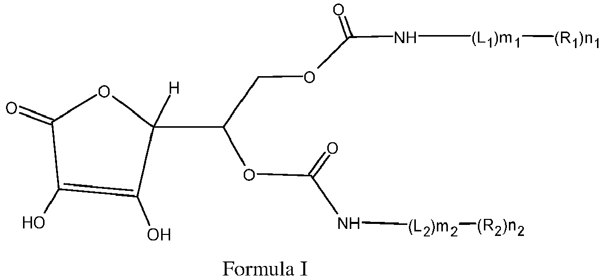
wherein m1, m2 are independently one of 0 - 1;
wherein n1, n2 are independently one of 0 - 1;
with the proviso that
m1 and n1 are not 0 at the same time and
m2 and n2 are not 0 at the same time;
whereby L1 and L2 comprise one or more, each independently selected from:
   a sulfonyl-group;
   or a linear or branched Cx-carbon chain (C), such as n-butyl,
   wherein x is chosen from 0 - 20, preferably 0 - 18,
   said carbon chain optionally being substituted;
   whereby R1 and R2 each independently represent:
      an aromatic group (Ar), such as a phenyl, optionally being substituted;
         or
      a cyclo-alkyl (CyC), such as cyclohexyl, optionally being substituted;
         or
      a group with a Si-atom (Si), preferably a silyl-group, such as a mono-, (di-) or trialkylsilyl; such as trimethylsilyl or a mono-, (di-) or tri- alkyloxysilyl; such as a triethoxysilyl;
         or
      an acrylate group (COOC), preferably an alkylacrylate, such as methacrylate.

Inventive insights have provided that the carbamate derive functions well as the stabilizer (S1 within the photosensitive composition as described earlier herein. According to an embodiment of the ascorbic acid derivative (AAD) represented by formula I,
m is 1; n is 1; and
L1 and L2 comprises a sulfonyl group;
R1 and R2 are each independently an Ar-group, preferably a C6-Aromatic group, optionally being substituted (e.g. with a methyl group).The sulfonyl group may provide for thermal stabilization due to a combination of electronic, steric, crosslinking, oxidation resistance, and stability properties. By including the aromatic, a bulky component can be achieved providing steric hindrance, limiting molecular motion and preventing the occurrence of thermally induced reactions. In this manner, stabilization can be achieved.

According to an embodiment of the ascorbic acid derivative (AAD) represented by formula I, m is 0; n is 1; and R1 and R6 are a C6-aromatic, such as phenyl.

According to an embodiment of the ascorbic acid derivative (AAD) represented by formula I, m is 1; n is 0; and L1 and L2 are each independently a Cx-chain, with x being 0 - 6 . Preferably, wherein L1 and L2 are a butyl, preferably n-butyl.

According to an embodiment of the ascorbic acid derivative (AAD) represented by formula I, m is 1; n is 1; and L1 and L2 are each independently a Cx-chain; with x being 0 - 6; preferably 3 (propyl); R1 and R2 are each independently a trialkyloxysilyl group, preferably triethoxysilyl-group.

According to an embodiment of the ascorbic acid derivative (AAD) represented by formula I, m is 1; n is 0; and L1 and L2 are each independently a Cx-chain; with x being 0 - 6; preferably 4 (t-Butyl).

According to an embodiment of the ascorbic acid derivative (AAD) represented by formula I, m is 1; n is 1; and L1 and L2 are each independently a Cx-chain; with x being 0 - 6; preferably 2 (ethyl). R1 and R2 are each independently an aklylacrylate, preferably methacrylate.

According to an embodiment of the ascorbic acid derivative (AAD) represented by formula I, m is 0; n is 1; and R1 and R2 are each independently cyclo alkyl, preferably a cyclohexyl.

According to an embodiment of the ascorbic acid derivative (AAD) represented by formula I, m is 0; n is 1; and R1 and R2 are each independently a trialkyloxysilyl group, preferably triethoxysilyl-group.

These aspects of the compound are based on the inventive insight that enhanced stabilization of thermally and/or radiation sensitive components can be provided. In particular, inventive insights provide for enhanced stabilized of compositions which include binder systems, such as organic apolar binder systems. More in particular, the ascorbic acid derivative (AAD) represented by formula I are of particular usefulness to stabilize binder systems comprising units chosen from styrene, butadiene, isoprene e.g. an SBS or SIS binders. The binders can be copolymers, such as duo or triblock polymers. Examples of binders that can be stabilzed are binders comprising Styrene-Isoprene-Styrene (SIS) units, Styrene-Ethylene-Butylene-Styrene (SEBS) or Styrene-Ethylene-Propylene-Styrene (SEPS) units and in particular the binders as described earlier herein.

A further aspect relates to a method to obtain an ascorbic acid derivative (AAD) as herein provided. The method comprising:
a) provision of an ascorbic acid (AA), preferably any one of D ascorbic acid or L ascorbic acid;
b) addition of an isocyanate (IC) and
   allowing the isocyanate to react with the ascorbic acid thereby obtaining an ascorbic acid derivative (AAD);

wherein the isocyanate (IC) is represented by formula II as: 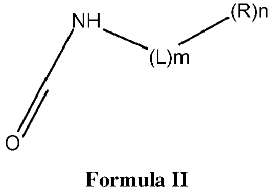 wherein
m and n are one of 0 - 1, with the proviso that m and n are not 0 at the same time;

whereby L comprises:
   a sulfonyl-group (e.g. -S atom coupled to two O atoms);
   or a linear or branched Cx-carbon chain (C), such as n-butyl,
   wherein x is chosen from 0 - 20, preferably 0 - 18,
   said carbon chain optionally being substituted;
whereby R represents:
   an aromatic group (Ar), such as a phenyl, optionally being substituted;
      or
   a cyclo-alkyl (CyC), such as cyclohexyl, optionally being substituted;
      or
   a group with a Si-atom (Si), preferably a silyl-group, such as a mono-, (di-) or trialkylsilyl; such as trimethylsilyl or a mono-, (di-) or tri- alkyloxysilyl; such as a triethoxysilyl;
      or
   an acrylate group (COOC), preferably an alkylacrylate, such as methacrylate.

Preferably, in said method, the isocyanate (IC) is selected from one of:
an alkoxysilyl alkyl isocyanate, such as (Triethoxysilyl)-propylisocyanat,
an alkyl silyl isocyanate, such as Trimethylsilyl-isocyanat,
an alkyl - aryl isocyanate, such as α,α-Dimethyl-3-isopropenyl-benzylisocyanate, 4-Isopropylphenyl isocyanate, m-tolyl isocyanate, p-tolyl isocyanate, or 2-phenylethylisocyanate;
an aryl isocyanate, such as phenylisocyanate or 1-naphthylisocyanate,
a cycloalkyl isocyanate, such as Cyclohexylisocyanat,
an alkyl methacrylate, such as 2-Isocyanatoethyl Methacrylate,
a alkyl isocyanate, such as tert.-Butylisocyanate, n-Butyl isocyanate, octadecylisocyanate or dodecyl isocyanate,
a sulfonyl isocyanate, such as p-Toluolsulfonyl-isocyanate,

Preferably, in said method, the reaction is performed at a temperature between 10 - 40 °C, such as room temperature, and without catalyst (K). More preferably, the reaction is performed at a temperature higher than 40 °C and with catalyst (K) or a mixture of catalysts, said catalysts being chosen from non-nucleophilic amine bases and lewis acids and combinations thereof e.g. Titanium(IV) (Triethanolaminato)isopropoxide, Zinc methacrylate, Zinc acetate, Dibutyltin dichloride, Dibutyltin di(acetate), DABCO (1,4-diazabicyclo[2.2.2]octane), TBD (1,5,7-Triazabicyclo[4.4.0]dec-5-ene), 1,8-Diazabicyclo(5.4.0)undec-7-ene (DBU), 2,2-Dimorpholinodiethylether (DMDEE), Bismuth 2-ethylhexanoate, preferably Di-n-butyl tin dilaurate. When several catalysts are used in combination, in particular the combination of a non-nucleophilic amine and lewis acid is preferred, such as DABCO and Di-n-butyl tin dilaurate.

For liquid or meltable isocyanates, the reaction might be performed without solvent. Preferably, in said method the reaction is performed within a solvent (S) or solvent mixture, preferably Dichloromethane (DCM), Trichloromethane (TCM), 1,4-Dioxane, Dimethyl sulfoxide (DMSO), Dimethyl carbonate (DMC), more preferably 2-Methyltetrahydrofuran (2-MeTHF), even more preferably Tetrahydrofuran (THF).

A further aspect relates to a photosensitive composition (PC') comprising an ethylenically unsaturated component (a); a thermal initiator and/or a photo initiator (b); a stabilizer (c), said stabilizer being a derivative (AAD) as described above in connection to formula I or the derivative obtained according the method as described above in connection to formula II.

Preferably, the photosensitive composition (PC') further comprising a binder (d), said binder being a SIS or SBS block copolymer and/or a binder as described earlier above.

A further aspect relates to the use of an ascorbic acid derivative having a carbamate functionality (CF), preferably at least two carbamate functionalities, for stabilizing a thermally or radiation sensitive components within a photosensitive composition (PC). Generally, the carbamate functionality can be recognized by the following structure:

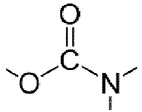

Preferably, wherein the photosensitive composition (PC) is comprised within a relief precursor, preferably a relief precursor to be developed into a relief structure, such as a printing plate or sleeve. Also, another aspect relates to the use of an ascorbic acid derivative as described above in connection to formula I or obtained according to method as described above in connection to formula II, for stabilizing thermally or radiation sensitive components within a photosensitive composition, such as a composition for use within a photosensitive layer of a relief precursor, for example to manufacture a printing plate.

Preferably, the relief precursor is a precursor of a printing plate or pad, in particular of the type for non-planographic printing, said type including precursors for flexographic printing, gravure printing or pad printing.

### DETAILED DESCRIPTION

### The photosensitive composition (PC)

Photosensitive composition is understood as a composition that can be cured by thermal and/or electromagnetic radiation (i.e. UV radiation). Curing can be understood as toughening or hardening the blend by crosslinking of the polymer chains within. The photosensitive composition described herein, can be used for a printing plate, flexographic plate, letter press plate, intaglio printing plate, microfluidic device, micro reactor, electrophoretic cell, photonic crystal or optical device. Partial exposure can be provided.

### Radical Initiator (R)

A " radical initiator " is typically the species that initiates the crosslinking within the photosensitive layer causing by producing free radicals e.g. as a result of exposure to heat or UV-radiation. The term radical initiator can be understood as a compound or substance that can produce radical species under mild conditions e.g. UV exposure and/or heating. This way the radical initiator can promote radical reactions. Suitable radical initiators typically have weak bonds and can be chosen based on having a small bond dissociation energies. Preferred radical initiator are preferably selected from a photoinitiator or photoinitiator system or thermal initiator. Such initiators are known to the person skilled in the art and described e.g. in: Bruce M. Monroe et al., Chemical Review, 93, 435 (1993), R. S. Davidson, Journal of Photochemistry and Biology A: Chemistry, 73, 81 (1993) M. Tsunooka et al., 25 Prog. Polym. Sci., 21, 1 (1996), F. D. Saeva, Topics in Current Chemistry, 1 56, 59 (1990), G. G. Maslak, Topics in Current Chemistry, 168, 1 (1993), H. B. Shuster et al., JACS, 112, 6329 (1990) and I. D. F. Eaton et al., JACS, 102, 3298 (1980), P. Fouassier and J. F. Rabek, Radiation Curing in Polymer Science and Technology, pages 77 to 117 (1993) or K.K. Dietliker, Photoinitiators for free Radical and Cationic Polymerisation, Chemistry & Technology of UV & EB Formulation for Coatings, Inks and Paints, Volume, 3, Sita Technology LTD, London 1991; or R.S. Davidson, Exploring the Science, technology and Applications of U.V. and E.B. Curing, Sita Technology LTD, London 1999. Further initiators are described in JP45-37377, JP44-86516, US3567453, US4343891, EP109772, EP109773, JP63138345, JP63142345, JP63142346, JP63143537, JP4642363, JP59152396, JP61151197, JP6341484, JP2249 and JP24705, JP626223, JPB6314340, JP1559174831, JP1304453 und JP1152109. An example of a suitable photoinitiator is benzyl dimethyl ketal (BDMK).

### Ethylenically unsaturated compound (EC)

Preferably, the photopolymer layer (also referred to as photosensitive layer) comprises further at least one component with at least one unsaturated group. Preferably, these components are reactive compounds or monomers which are suitable for the preparation of the mixtures are those which are polymerizable and are compatible with the binders. Useful monomers of this type generally have a boiling point above 100 °C. They usually have a molecular weight of less than 3000 g/mol, preferably less than 2000 g/mol. More preferably, the ethylenically unsaturated monomers are used that ought to be compatible with the binders, and they have at least one polymerizable, ethylenically unsaturated group. As monomers it is possible in particular to use esters or amides of acrylic acid or methacrylic acid with mono- or polyfunctional alcohols, amines, aminoalcohols or hydroxyethers and hydroxyesters, esters of fumaric acid or maleic acid, and allyl compounds. Esters of acrylic acid or methacrylic acid are even more preferred. Preference is given to 1,4-butanediol diacrylate, 1,6-hexanediol diacrylate, 1,6-hexanediol dimethacrylate, 1,9-nonanediol diacrylate, or trimethylolpropane tri(meth)acrylate. Mixtures of different monomers can of course be used. The total amount of all the monomers used in the relief-forming layer together is generally 1 to 20 wt%, preferably 5 to 20 wt%, based in each case on the sum of all the constituents of the relief-forming layer. The amount of monomers having two ethylenically unsaturated groups is preferably 5 to 20 wt%, based on the sum of all constituents of the relief-forming layer, more preferably 8 to 18 wt%.

### Binders (B)

The preferred binder (B) is a thermoplastic elastomer block copolymer, e.g. a diblock copolymer or triblock copolymer. A thermoplastic is a class of polymer that can be softened through heating and then processed. This behavior is advantageous and cause the possibility of producing relief precursor in larger volumes, e.g. by extrusion. Also, processes like injection moulding, thermoforming and blow moulding can be used when using thermoplastic elastomer block copolymer binders. The choice of thermoplastic binder is advantageous over e.g. SBR rubbers (belonging to the thermoset elastomers) which do not perform well in high volume extrusion production processes.

The binder (B) has a first monomer unit being a vinyl aromatic monomer and a second monomer unit, said second monomer unit being an ene-monomer and/or a diene-monomer. An ene-monomer refers to a monomer that contains a carbon-carbon double bond (C=C) in its molecular structure. A diene-monomer refers to a monomer that contains two carbon-carbon double bonds (C=C=C) in its molecular structure.

The vinyl aromatics may be, for example, styrene, α-methylstyrene, or vinyltoluene. Styrene is preferable. The dienes are preferably butadiene and/or isoprene. These block copolymers may be linear, branched, or radial block copolymers. Generally speaking, they are triblock copolymers of the A-B-A type, but they may also be diblock polymers of the A-B type, or may be polymers having a plurality of alternating elastomeric and thermoplastic blocks. A-B-A-B-A, for example.

In addition star like copolymers and/or branched copolymers may be used or combinations thereof. Mixtures of two or more different block copolymers may also be used. Commercial triblock copolymers frequently include certain fractions of diblock copolymers. The diene units may be 1,2- or 1,4-linked. The double bonds in the backbone of the binders provide a crosslink capability between, among others, the binders in the photosensitive layer causing the curing upon exposure of the relief precursors. Also possible for use, furthermore, are thermoplastic elastomeric block copolymers with styrene and blocks and a random styrene-butadiene middle block. Use may also be made, of course, of mixtures of two or more thermoplastic-elastomeric binders, provided that the properties of the relief-forming layer are not negatively impacted as a result. As well as the stated thermoplastic-elastomeric block copolymers, the photopolymerizable layer may also comprise further elastomeric binders other than the block copolymers. With additional binders of this kind, also called secondary binders, the properties of the photopolymerizable layer can be modified. Examples of a secondary binder are vinyltoluene-a-methylstyrene copolymers.

These polymer binders account for in general from 20 to 98%, preferably from 50 to 90% by weight of the total composition. Copolymers, such as styrene-butadiene-styrene (SBS) or styrene-isoprene-styrene (SIS) diblock or triblock copolymers, exhibit benefits over random copolymers, e.g. styrene-butadiene rubber

### SBR.

Random copolymers such as SBR are not to be confused with the styrene-butadiene block copolymer, although being derivable from the same monomers. Random SBR is often used for elastomeric products such as tires, shoe soles, or seals. Due to its irregular molecular structure, SBR does not have a well pronounced microphase separation. As a result, uncured SBR polymers without fillers would not keep their shape during storage. Thus, the addition of filler materials as well as contemporary curing of SBR is required to preserve the shape and to enhance its physical properties. Nevertheless, any filler material added to a printing plate precursor formulation would scatter the UV light and disturb the crosslinking process during intentional curing by UV light.

By curing of SBR, which is realized typically by reaction with sulfur, the filler enhanced SBR polymer becomes elastomeric. As the structure is preserved by chemical bonds, cured SBR decomposes under heat rather than melts, and is therefore no thermoplastic.

In contrast to (thermoset) SBR random polymers, styrene-butadiene block copolymers are thermoplastic elastomers. They can be melted, mixed and shaped under heat without the need of a solvent. The block copolymer configuration of e.g. SBS or SIS results in a microphase separation of polystyrene and polybutadiene or polyisoprene domains. The elastomeric behavior roots in this network of physical crosslinks with an elastic block (polybutadiene) and a restraining block (polystyrene). Printing plate precursors based on styrene-butadiene block copolymers do mostly keep their shape also during longer storage times, typically for one to two years after production. A long storage time is essential for printing plate precursors, as curing of the printing plate precursors takes place not at the production site but rather at repro houses or printing facilities. To conclude, in contrast to block copolymers, SBR as a random copolymer is not a suitable binder for printing plate precursors. Examples of binders are shown below.

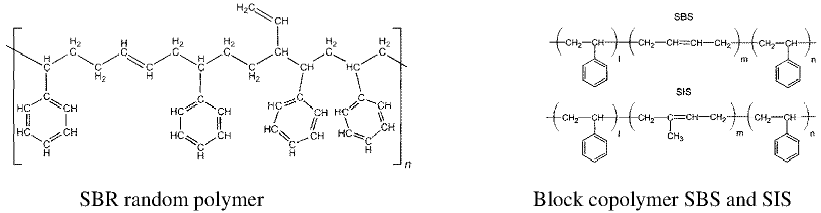

It is preferred that the binder has a total styrene content in the range of 3 - 50 %, preferably 8 - 38 %, more preferably 10 - 35 %, most preferably 14 - 32 %. These ranges improve the Newtonian behavior of the binder and can set both kinematic and dynamic viscosities of the binder suitable for extrusion production. Preferably, the binder is chosen from the binder (B) is chosen from a styrene-butadiene-styrene (SBS) triblock copolymer and/or a styrene-isoprene-styrene (SIS) triblock copolymer.

In an embodiment, the binder is chosen from an SBS triblock copolymer
having a styrene content in the range of 8 - 48 %, preferably 13 - 43 %, more preferably 18 - 38 %, e.g. around 28 %.

In an embodiment, the binder is chosen from a SIS triblock copolymer having a styrene content in the range of 3 - 27 %, preferably 5 - 25 % e.g. around 15 %.

In an embodiment, the binder is a diblock copolymer or has triblock copolymer with a diblock fraction in the range of 5 - 30 %, preferably 8 - 28 %, more preferably 10 - 24 %, e.g. around 17 % or 19%. Such fractions has been found to be suitable for extrusion processing.

### Stabilizer (S1)

The term "stabilizer" is understood as a member, preferably but not functionally limited to having a stabilizing effect. The stabilizer S1 is a vitamin or vitamin derivative and shall be discussed further below.

### Vitamin or vitamin derivative

The term vitamin is known and includes several chemical structures. Traditionally vitamins are separated into two groups, the water-soluble and the fat-soluble vitamins. The water-soluble vitamins are thiamin, riboflavin, niacin, vitamin B6, folic acid, vitamin B12, pantothenic acid, biotin, and vitamin C. The fat-soluble vitamins are vitamin A, vitamin E, vitamin D, and vitamin K.

Surprisingly, it has now been found that the vitamins and derivatives thereof have a stabilizing effect towards the thermal and mechanical stress towards which the melt of the thermoplastic elastomeric binder systems is exposed to during production of the relief precursor. Moreover, vitamins can be used within a relief precursor to improve storage stabilization. Also, the developing characteristics of the precursor can be improved such that reliefs formed therefrom can achieve improved imaging characteristics. These imaging characteristics include, among others, smaller dot size after development and the achieved dot size can be closer to target value. Exemplary vitamin types are shown in the table below.

| **Vitamin type** | **Chemical Name** | **OWc** | **Chemical structure (Example)** |
|---|---|---|---|
| Vitamin A | Retinol | 7.62 | 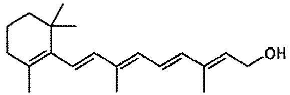 |
| Vitamin B1 | Thiamin | -3.93 | 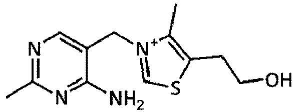 |
| Vitamin B5 | Phantothenic acid | -1.69 | 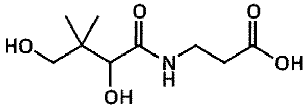 |
| Vitamin B6 | Pyridoxine | -0.56 | 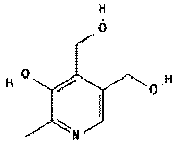 |
| | Pyridoxine hydrochloride Vit B6 hydrocloride | | 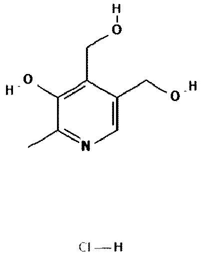 |
| Vitamin B7 | Biotin | 0.39 | 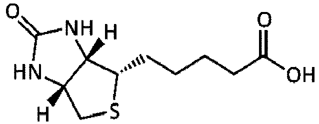 |
| Vitamin B9* | Folic Acid | -2.81 | 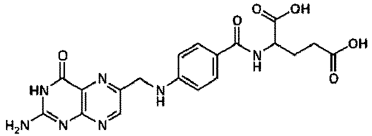 |
| Vitamin C | Ascorbic acid | -1.88 | 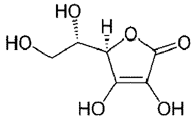 |
| Vitamin C derivative* | Ascorbyl palmitate (AP) | 6.00 | 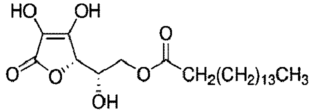 |
| Vitamin D | Cholecalciferol | 10.24 | 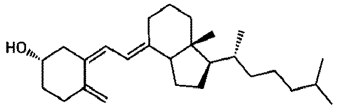 |
| Vitamin E | Alpha-Tocopherol | 12.18 | 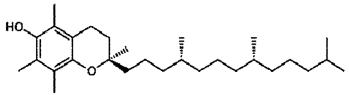 |

In an embodiment, the stabilizer (S 1) is chosen from one or more of folic acid (Vitamin B9), ascorbyl palmitate (Vitamin C derivative), and pyridoxine hydrochloride (Vitamin B6).

These stabilizers have been found to achieve a high thermal stabilization, this way the relief precursors can be stored over a prolonged period of time without impacting the quality of the relief structures formed later on.

In a preferred embodiment, the structure of the vitamin or vitamin derivative includes a first group (G1) chosen from an aromatic group or a cyclic unsaturated group to which at least one -OH group is coupled and preferably a second group (G2), e.g. an apolar moiety, said second group being a linear or branched carbon chain lacking a permanent electric dipole moment or of which the dipole moment is minimal. The cyclic unsaturated group preferably comprises a furan group comprising a five-membered aromatic ring with four carbon atoms and one oxygen atom. The number of carbon atoms in the backbone of the second group is preferably chosen from any of 2 to 25, 3 to 20, 3 to 17, 3 to 16 carbons atoms. The chain may be substituted as long as the symmetry of the charge density distribution in the chain is kept equally distributed so as to have the lack of or minimal dipole moment in the chain. The second group may improve the compatibility with organic binder systems within a photosensitive composition (PC) while the first group may avoid the start of an unintended curing reaction, e.g. by capturing free radicals. Preferably the first group (G1) includes at least two -OH groups, which -OH groups are each coupled to a double bonded C-atom.

In an embodiment, the stabilizer (S1) includes a sub structure chosen from hydroxytetronic acid (HTAD) or a modified version thereof. Modifications may improve the compatibility with the binder system.

Preferred stabilizers (S1) for stabilizing a thermally and/or radiation sensitive components comprise hydroxytetronic acid 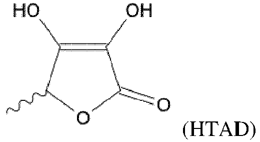 as a sub structure.

Derivatives of a hydroxytetronic acid (HTAD) are believed to cause stabilizing effects and can therefore be beneficial to include within a photosensitive composition. The hydroxytetronic acid derivative, also referred to herein as HTAD, is preferably a reductone, containing an enediol structure stabilized by conjugation and hydrogen bonding with an adjacent carbonyl group, RC(OH)=C(OH)C(=O)R. Reductones are efficient reducing agents and antioxidants able to react with oxygen and hydroxyl radicals.

A particular efficiency was found when the HTAD derivative contains further one or more solubilizing moieties. These solubilizing moieties contribute to the homogeneous distribution in the respective binder and its different phases. For example, SBS and SIS rubber contain a styrene and butadiene or isoprene phase, which needs to be stabilized appropriately.

Depending on the overall formulation, e.g. monomers can accumulate in one of the phases or both phases, depending on the specific monomer structure. By utilizing the appropriate HTAD derivative, binder and monomer combination, an exceptional stabilization under the influence of air and heat is achieved. In an embodiment, the stabilizer (S1) is an ascorbic acid derivative, e.g. ascorbyl palmitate, L-ascorbic acid, D-Isoascorbic acid, L-ascorbyl monostearate, sodium L-ascorbate and sodium D-isoascorbate. Exemplary structures are shown below.

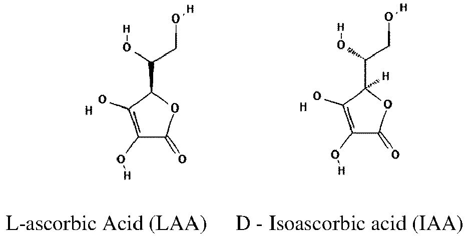

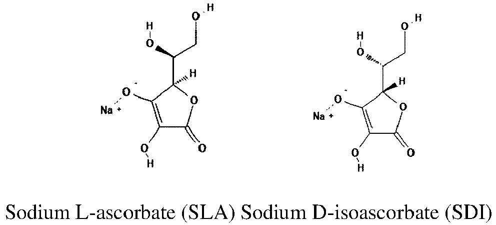

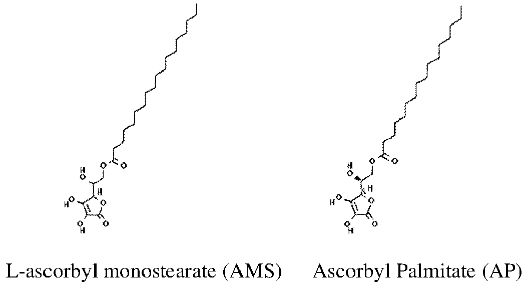

In an embodiment, the vitamin or vitamin derivative is chosen from sodium D-isoascorbate (SDI) or ascorbyl palmitate (AP).

In an embodiment, the stabilizer (S1) is chosen from an ascorbic acid or vitamin derivative with the proviso that the stabilizer is not chosen from ascorbic acid (176g/mol), L-ascorbyl monostearate (AMS) (442g/mol), sodium L-ascorbate (198g/mol) and sodium D-isoascorbate (198g/mol).

A preferred stabilizer is Ascorbyl Palmitate (AP) (414 g/mol) as the latter has improved free radical scavenging properties.

The stabilizer (S1) is preferably present in a concentration of 0.1 to 10 wt.%, preferably 0.1 to 8 wt%, more preferably 0.2 to 6 wt% based on the total weight of the composition. It has been found that in this way, extrusion stability can be improved without or with minimal impact on the curing capabilities of the photosensitive composition. By reducing (undesired) impact on the (final) curing capabilities, e.g. the curing during development of the relief precursor, final printing properties can be achieved.

In a preferred embodiment, the stabilizer (S1) can be the ascorbic acid derivative (AAD) represented by formula I as described herein or stereo isomeric forms thereof.

In a preferred embodiment the ascorbic acid derivative (AAD) is obtained by
a) provision of an ascorbic acid (AA), preferably any one of D ascorbic acid or L ascorbic acid;
b) addition of an isocyanate (IC) and allowing the isocyanate to react with the ascorbic acid thereby obtaining an ascorbic acid derivative (AAD); wherein the isocyanate (IC) is represented by formula II as described herein.

To obtain various degrees of functionalization and/or preferred characteristics, the isocyanate component can varied with respect to ascorbic acid (=1 molar eq.) between 0.1 and 10 eq., preferably 0.1 - 5 eq., more preferably 0.5 - 3 eq., even more preferably 1-2 eq., most preferably 2 eq.

The reaction temperature can be varied from 0 to 80 °C, more preferably 20 - 80 °C, even more preferably 60 - 80 °C. Different catalyst can be chosen among non-nucleophilic amine bases and lewis acids and combinations thereof (e.g. Titanium(IV) (Triethanolaminato)isopropoxide, Zinc methacrylate, Zinc acetate, Dibutyltin dichloride, Dibutyltin di(acetate), (1,4-diazabicyclo[2.2.2]octane (DABCO), 1,5,7-Triazabicyclo[4.4.0]dec-5-ene (TBD), DBU (1,8-Diazabicyclo(5.4.0)undec-7-ene), DMDEE (2,2-Dimorpholinodiethylether), Bismuth 2-ethylhexanoate). The catalyst concentration can be varied between 0.01 - 1 eq., more preferably 0.02 - 0.5 eq., even more preferably 0.03 - 0.2 eq., most preferably 0.05 - 0.1 eq with respect to ascorbic acid (=1 molar eq.).

Different solvents can be used, e.g. Dichloromethane (DCM), Trichloromethane (TCM), 1,4-Dioxane, Dimethyl sulfoxide (DMSO), Dimethyl carbonate (DMC), more preferably 2-Methyltetrahydrofuran (2-MeTHF), even more preferably Tetrahydrofuran (THF).

Solvents can be tested and the concentration was varied from 5 - 99 w% solvent, preferably 30 - 90 w% solvent, more preferably 50 - 90 w% solvent, even more preferably 50 - 70 w% solvent, most preferably 60 - 70 w% solvent. For liquid isocyanates it is possible to conduct the reaction without additional solvent.

### Second stabilizer (S2)

It has been found that when a vitamin or vitamin derivative, in particular an ascorbic acid derivative is combined with a second stabilizer typically used in relief precursor compositions, that such combines enhances the thermal stability of the composition in synergistic manner.

The second stabilizer S2, is preferably chosen from one of the following classes: phenolic, phenolic and acrylate, thioether, hindered amine, phenolic and amine, amine, thioether amine, a multifunctional amine and acrylate. Surprisingly, the vitamin derivative, preferably an ascorbic acid derivative can enhance the thermal stability of the second stabilizer in a synergistic manner.

In an embodiment, the second stabilize (S2) is chosen from one or more of 2,6-di-tert-butyl-4-methylphenol (BHT), 2-tert-Butyl-6-(3-tert-butyl-2-hydroxy-5-methylbenzyl)-4-methylphenyl acrylate, Pentaerythritol tetrakis(3-(3,5-di-tert-butyl-4-hydroxyphenyl)propionate), Tris(2,4-di-tert-butylphenyl) phosphite, Didodecyl 3,3'-thiodipropionate, 1,5,8,12-Tetrakis[4,6-bis(N-butyl-N-1,2,2,6,6-pentamethyl-4-piperidylamino)-1,3,5-triazin-2-yl]-1,5,8,12-tetraazadodecane, 2',3-Bis[[3-[3,5-di-tert-butyl-4-hydroxyphenyl]propionyl]]propionohydrazide, Bis[4-(2-phenyl-2-propyl)phenyl]amine, 2,6-Di-tert-butyl-4-(4,6-bis(octylthio)-1,3,5-triazin-2-ylamino)phenol, a tertiary amine and acrylate, preferably 1H-Azepine-1-propanoic acid, hexahydro-, 2,2-bis[[(1-oxo-2-propen-1-yl)oxy]methyl]butyl ester or 2,2-Bis[[(1-oxo-2-propen-1 -yl)oxy]methyl]butyl hexahydro-1H-azepine-1-propanoate.

### Additives

The photopolymer layer may comprise further components. The further components are selected from the group consisting of a further polymer, a filler, a plasticizer, an anti-blocking agent, a monomer, an additive (e.g. a stabilizer, a dye), a crosslinker, a binder, a color forming compound, a dye, a pigment, an antioxidant and combinations thereof.

### Plasticizer

The photosensitive composition (PC) may further comprise a plasticizer. Suitable plasticizers encompass modified and unmodified natural oils and natural resins, such as high- boiling paraffinic, naphthenic or aromatic mineral oils, synthetic oligomers or resins such as oligo styrene, high-boiling esters, oligomeric styrene-butadiene copolymers, oligomeric alpha-methylstyrene/p-methylstyrene copolymers, liquid oligobutadienes, especially those having a molecular weight of 500 to 5000 g/mol, or liquid oligomeric acrylonitrile-butadiene copolymers or oligomeric ethylene-propyl-ene-diene copolymers. Preference is given to polybutadiene oils (liquid oligobutadienes), especially those having a molecular weight of 500 to 5000 g/mol, high-boiling aliphatic esters such as, in particular, alkyl esters of monocarboxylic and dicarboxylic acids, examples being stearates or adipates and mineral oils. Particularly preferred are high-boiling, substantially paraffinic and/or naphthenic mineral oils. It is possible, for example, to use what are called paraffin-base solvates and specialty oils. With mineral oils, the skilled person distinguishes between technical white oils, which may also include a very small aromatic content, and medical white oils, which are substantially free from aromatics. They are commercially available and equally well-suited. Particularly widespread as plasticizers are white oils or oligomeric plasticizers, such as, in particular, polybutadiene oils, carboxylic esters, phthalates. In this regard, reference may be made by way of example to EP 992 849 and EP 2 279 454.

In some embodiments, a bio-based plasticizer can be used to promote processing behavior during e.g. extrusion processes. The bio-based plasticizer is typically partially derived from renewable, biological resources such as plants (e.g. agricultural crops or wood), microorganisms (e.g. algae or yeasts), or animals as described in the international application: PCT/EP2022/062430 included herein by reference.

Bio-based plasticizers are at least partially derived from renewable, biological resources such as plants (e.g. agricultural crops or wood), microorganisms (e.g. algae or yeasts), or animals. Bio-based plasticizers are environmental friendly, often but not necessary biodegradable. Bio-based materials may be chemically altered, or modified with synthetic compounds, to change for example physical and/or chemical properties. They then still remain bio-based materials. These plasticizers are generally used to maintain softness and flexibility at varying temperature ranges. These plasticizers can at least partly replace other plasticizers, like synthetic plasticizers. Many of the non-bio-based plasticizers, especially the so-called phthalates, are harmful to one's health and may affect the hormone balance. Others are mineral oil or polybutadiene based and not easily biodegradable. It is thus advantageous to at least partly replace them by bio-based plasticizers. We furthermore found that when bio-based plasticizers are being used that for thermal development, a higher relief depth can be achieved for all concentrations investigated. Moreover, we found that using for example rapeseed oil instead of mineral oil this allows for higher washout speeds and results in shorter process times. More preferably, the bio-based plasticizer is a vegetable oil, a fatty acid and/or a fatty acid ester of mono and polyfunctional alcohols with one or less free hydroxyl group. More preferably, the bio-based plasticizer is one or more of rapeseed oil, sunflower oil, soybean oil, palm oil, palm kernel oil, coconut oil, medium-chain triglycerides (MCT) oil and/or linseed oil. Further examples are açaí oil, adeps lanae, ahiflower oil, algea oil, aloe vera, amaranth oil, apricot kernel oil, argan oil, avocado oil, babassu oil, baobab oil, beeswax, black cumin oil, black cumin seed oil, blackcurrant oil, borage oil, brazilnut oil, broccoliseed oil, calendula oil, camelina oil, candelilla wax, carnauba wax, castor oil, cocoa butter, chia oil, chilean hazelnut oil, cocoa butter, corn oil, cotton seed oil, cupuaçu butter, evening primrose oil, fish oil, glycerol, grape seed oil, groundnut oil, hazelnut oil, hemp oil, high-oleic canola oil, high oleic soybean oil, high oleic sunflower oil, illipe butter, jatropha curcas oil, jojoba oil, kukuinut oil, lanolin, laurel oil, macadamia nut oil, marula oil, mango butter, manketti oil, marula oil, meadowfoam seed oil, milk thistle oil, moringa oil, murumuru butter, mustardseed oil, olive oil, olus oil, omega-3-6-9-oil, palmolein, palm stearin, paradise nut oil, passionfruit seed oil, peach kernel oil, peanut oil, pecan nut oil, perilla oil, pistachio nut oil, plum kernel oil, pomegranate oil, poppyseed oil, pumpkin seed oil, rapeseed oil hydrogenated, raw wool grease, rice bran oil, rose hip kernel oil, sacha inchi oil, safflower oil, sal fat, sea buckthorn oil, sesame oil, shea butter, soybean oil hydrogenated, soybean oil partially hydrogenated, squalane, sunflower oil hydrogenated, sunflower wax, sumac wax, tallow, tamanu oil, walnut oil, wheat germ oil, wool fat, wool alcohols. Different types of plasticizer might be combined to fine-tune the properties of the layer. E.g. a bio-based plasticizer can be used in as an alternative or in addition to the plasticizers described above. The amount of a plasticizer optionally present can be determined according to the desired properties of the layer.

The bio-based plasticizer may have one or more of the features below:
- wherein the plasticizer is a bio-based plasticizer, preferably a vegetable oil, a fatty acid and/or a fatty acid ester of mono and polyfunctional alcohols.
- wherein the plasticizer is characterized by a UV transmission at 365 nm of a solution of 33 wt% plasticizer in n-hexane of higher than 1%, preferably higher than 10%, more preferably higher than 50%, even more preferably higher than 60%.
- wherein the plasticizer is characterized by a Gardner color lower than 7 according to ISO 4630:2015.
- wherein the plasticizer is characterized by a hydroxyl value according to ASTM D1957-86 below 430, preferably below 250, even more preferably below 168.
- wherein the plasticizer has an iodine value according to ISO 3961:2018 below 200, preferably below 150.
- wherein the plasticizer has a Hansen solubility parameter δt in the range of 16.0 to 20.5, preferably in the range of from 16.0 up to 17.5.

Determination of UV transmission: The UV transmission at 365 nm was measured in n-hexane with a plasticizer concentration of 5 parts by weight in a macro-cuvette 110-QS, 10 mm. The UV/Vis spectrum was recorded on a Varian Cary 50, scan Software version: 02.00, beam mode: Dual Beam. A baseline correction was performed with a blank sample of pure n-hexane and applied with the integrated software of the instrument.

Determination of the light transmission: The pure oil was filled in a macro-cuvette 110-QS, 10 mm and the light transmission measured by putting the cuvette in a densitometer Gretag Macbeth D 200 II (measuring tube: V (λ), measuring aperture: 3 mm diameter) and pressing the probe head on the macro-cuvette. The measurement of the transparent MCT-oil, which is resistant towards oxidation due to the lack of double bonds, was set as standard with 100% transmission. The mean value of 3 measurements was determined. For more details on the bio-based plasticizer, reference is made to PCT/EP2022/062430, which is incorporated herein by reference.

The concentration of the plasticizer in the photopolymer layer (also referred to herein as photosensitive layer) is preferably in the range of from 3 up to 70 wt%, preferably in the range of from 5 to 65%, more preferably in the range of from 10 up to 65 wt%, even more preferably in the range of from 20 up to 60 wt%, based on the total weight of the photopolymer layer.

### The relief precursor (RP)

The relief precursor (RP) includes a photopolymer layer (also called photosensitive layer L2) as described above which is applied on a dimensionally stable support (L1), also referred to as a dimensionally stable carrier layer (L1). Such support layer can be a PET sheet. Preferably, the carrier layer L1 comprises a metal sheet, a steel, an alloy, a natural or artificial polymer, a polymer blend, a polymer film, or any combination thereof. Examples of suitable dimensionally stable carriers are plates, foils, and also conical and cylindrical tubes, known as sleeves, made of metals such as steel, aluminum, copper or nickel, or of plastics such as polyethylene terephthalate, polybutylene terephthalate, polyamide or polycarbonate, of wovens or nonwovens such as woven glass fiber fabric, or of composite materials composed of glass fibers and plastics. Particularly suitable as dimensionally stable carriers are dimensionally stable carrier foils or metal sheets, examples being polyethylene or polyester foils or steel or aluminum sheets. The carrier foils or metal sheets have a thickness, generally speaking, of 50 to 1500 µm, preferably 75 to 400 µm, for example around 250 µm. If steel is used as carrier material, steel sheets having a thickness of 0.05 to 0.3 mm are preferred. For protection against corrosion, preference is given to using tin-plated steel sheets. These carrier foils or carrier sheets may be coated with a thin, adhesion-promoting layer, for example a layer 0.1 µm to 2 µm thick, on the side of the carrier foil facing the radiation-curable, relief-forming layer. In a preferred embodiment, the carrier layer is a PET carrier layer made from polyethylene terephthalate.

Typically, at least the photosensitive layer L2 comprises the photosensitive composition as described herein. Preferably, photosensitive layer L2 has a thickness of in the range of 25 µm to 7000 µm, preferably 0.01 to 4 mm, more preferably 0.02 to 3 mm, and very preferably 0.03 mm to 3 mm.

The relief furthermore comprise a mask layer L3, the mask layer comprising at least a compound capable of absorbing electromagnetic radiation and a component capable of being removed by ablation (also known as digital plate precursor).

The references L1, L2 and L3 for the layers can but are in no way intended to be limited to a particular sequence. The relief precursor may include further layers if needed, e.g. an oxygen blocking barrier layer, an adhesion layer, a release layer or a disbonding layer, UV/VIS light and/or IR light absorbing layer, a monomer diffusion control layer, a surface control layer, a protection layer, a cover foil, a cover film or combinations thereof. In an embodiment, there may be an adhesion coating layer with an optional top coating layer thereon. Such adhesion coating layers may be, for example, layers of polyurethane adhesion coating materials, as described in DE3045516 for example.

Preferably the mask layer is an integral layer of the relief precursor and is in direct contact with the photosensitive layer or with a functional layer disposed between photosensitive layer and mask layer. This functional layer is preferably a barrier layer and blocks oxygen. The mask layer may be imageable by ablation and removable by solvents or by thermal development. The mask layer is heated and removed by irradiation with high energy electromagnetic radiation, whereby an image wise structured mask is formed, which is used to transfer the structure onto the relief precursor. In order to do so the mask layer may be non-transparent in the UV region and absorb radiation in the VIS-IR region of the electromagnetic spectrum. The VIS-IR radiation may then be used to heat and ablate the layer. The optical density of the mask layer in the UV region between 330 and 420 nm is in the range of 1 to 5, preferably in the range of 1.5 to 4 and more preferably in the range of 2 to 4.

The layer thickness of the ablatable mask layer may be in the range of 0.1 to 5 µm, preferably 0.3 to 4 µm, more preferably 1 to 3 µm. The laser sensitivity of the mask layer (measured as energy needed to ablate 1 cm²) may be in the range of 0.1 to 10 J/cm², preferably in the range of 0.3 to 5 J/cm², most preferably in the range of 0.5 to 5 J/cm².

### Developing the relief precursor (RP) and production of a relief (RS) with relief structures

The relief precursor can be imaged by ablation of a mask layer, by exposure through mask or by direct imaging. This way, the precursor can be developed into a relief (e.g. a cliché) with relief structures. The mask layer can be a separate layer, which is applied to the relief precursor following the removal of a protective layer that may possibly be present, or an integral layer of the precursor, which is in contact with the relief layer or one of the optional layers above the relief layer, and is covered by a protective layer that may possibly be present.

The mask layer can also be a commercially available negative which, for example, can be produced by means of photographic methods based on silver halide chemistry. The mask layer can be a composite layer material in which, by means of image-based exposure, transparent layers are produced in an otherwise non-transparent layer, as described, for example in EP 3 139 210 A1, EP 1 735 664 B1, EP 2987 030, A1 EP 2 313 270 B1. This can be carried out by ablation of a non-transparent layer on a transparent carrier layer, as described, for example, in US 6,916,596, EP 816 920 B1, or by selective application of a non-transparent layer to a transparent carrier layer, as described in EP 992 846 B1, or written directly onto the relief-forming layer, such as, for example, by printing with a non-transparent ink by means of ink-jet, as described, for example, in EP 1 195 645 A1.

Image wise removal of the mask layer is preferably performed using ablation technology. As a rule, the electromagnetic radiation for ablating the mask will generally be radiation having a wavelength in the range from 300 nm to 20000 nm, preferably in the range from 500 nm to 20000 nm, particularly preferably in the range from 800 nm to 15000 nm, very particularly preferably in the range from 800 nm to 11000 nm. In addition to solid-body lasers, gas lasers or fiber lasers can also be used. Preferably, in laser ablation, use is made of Nd:YAG lasers (1064 nm) or CO2-lasers (9400 nm and 10600 nm). For the selective removal of the mask layer, one or more laser beams are controlled such that the desired printing image is produced.

The direct image exposure can be achieved in that the regions to be cross-linked are exposed selectively. This can be achieved, for example, with one or more laser beams which are controlled appropriately, by the use of monitors in which specific image points which emit radiation are activated, by using movable LED strips, by means of LED arrays, in which individual LEDs are switched on and off specifically, by means of the use of electronically controllable masks, in which image points which allow the radiation from a radiation source to pass are switched to transparent, by means of the use of projection systems, in which by means of appropriate orientation of mirrors, image points are exposed to radiation from a radiation source, or combinations thereof. Preferably, the direct exposure is carried out by means of controlled laser beams or projection systems having mirrors. The absorption spectra of the initiators or initiator systems and the emission spectra of the radiation sources must at least partly overlap.

The wavelength of the electromagnetic radiation lies in the range from 200 nm to 20000 nm, preferably in the range from 250 nm to 1100 nm, particularly preferably in the UV range, very particularly preferably in the range from 300 nm to 450 nm. Besides broadband irradiation of the electromagnetic radiation, it can be advantageous to use narrow-band or monochromatic wavelength ranges, such as can be produced by using appropriate filters, lasers or light emitting diodes (LEDs). In these cases, wavelengths of 350 nm, 365 nm, 385 nm, 395 nm, 400 nm, 405 nm, 532 nm, 830 nm, 1064 nm (and about 5 nm to 10 nm below and/or above this), on their own or in combination, are preferred.

The relief is generated by exposure with electromagnetic radiation through a mask film. On exposure, the exposed regions undergo crosslinking, whereas the unexposed regions of the precursor remain soluble or liquefiable and are removed by appropriate methods. Where an imaged mask is present, irradiation may take place extensively, or, if operating without a mask layer, irradiation may take place in an imaging way over a small area (virtually dotwise) by means of guided laser beams or positionally resolved projection of electromagnetic radiation. The wavelength of the electromagnetic waves irradiated in this case is in the range from 200 to 2000 nm, preferably in the range from 200 to 450 nm, more preferably in the range form 250 nm to 405 nm. The irradiation may take place continuously or in pulsed form or in a plurality of short periods with continuous radiation. In addition to broadband radiation of the electromagnetic waves, it may be advantageous to use narrow-band or monochromatic wavelength ranges, as can be generated using appropriate filters, lasers or light-emitting diodes (LEDs).

In these cases, wavelengths in the ranges 350, 365, 385, 395, 400, 405, 532, 830, 1064 nm individually (and about 5-10 nm above and / or below) or as combinations are preferred. The intensity of the radiation here may be varied over a wide range, ensuring that a dose is used which is sufficient to cure the radiation-curable layer sufficiently for the later development procedure. The radiation-induced reaction, possibly after further thermal treatments, must be sufficiently advanced that the exposed regions of the radiation-sensitive layer become at least partially insoluble and therefore cannot be removed in the developing step.

The intensity and dose of the radiation are dependent on the reactivity of the formulation and on the duration and efficiency of the developing.

The intensity of the radiation is in the range from 1 to 15000 mW/cm², preferably in the range from 5 to 5000 mW/cm², more preferably in the range from 10 to 1000 mW/cm². The dose of the radiation is in a range from 0.3 to 6000 J/cm², preferably in a range from 3 to 100 J/cm², more preferably in the range from 6 to 20 J/cm². Exposure to the energy source may also be carried out in an inert atmosphere, such as in noble gases, CO2 and/or nitrogen, or under a liquid which does not damage the relief precursor. Exposure through the mask can be done by using optical devices, for example for beam widening, by a two-dimensional arrangement of multiple point-like or linear sources (for example light guides, emitters), such as fluorescent strip lamps arranged beside one another, by moving a linear source or an elongated arrangement of LEDs (array) relative to the relief precursor, for example by a uniform movement of LEDs or combinations thereof. Preferably, fluorescent strip lamps arranged beside one another or a relative movement between one or more LED strips and the relief precursor is used.

The irradiation can be carried out continuously, in a pulsed manner or in multiple short periods with continuous radiation.

The removal of the non-cured areas of the precursor is preferably performed by treatment with heat and a developing material configured to adsorb non-cured material. More preferably, in step d) the precursor is heated to a temperature in the range of 70 to 200 °C, preferably in the range of 80 to 180 °C, more preferably in the range of 90 to 165 °C. The heating of the exposed relief precursor may be carried out by all of the techniques known to the skilled person, such as, for example, by irradiation with IR light, the action of hot gases (e.g., air), using hot rollers, or any desired combinations thereof. To remove the (viscously) liquid regions it is possible to employ all techniques and processes familiar to the skilled person, such as, for example, blowing, suction, dabbing, blasting (with particles and/or droplets), stripping, wiping, transfer to a developing medium, and any desired combinations thereof. Preferably the liquid material is taken up (absorbed and/or adsorbed) by a developing medium which is contacted continuously with the heated surface of the relief precursor. The procedure is repeated until the desired relief height is reached. Developing media which can be utilized are papers, woven and nonwoven fabrics, and films which are able to take up the liquefied material and may consist of natural fibers and/or polymeric fibers. Preference is given to using nonwovens or non-woven fiber webs of polymers such as celluloses, cotton, polyesters, polyamides, polyurethanes, and any desired combinations thereof, which are stable at the temperatures employed when developing. Alternatively the precursor is treated with a developing liquid to dissolve non-cured material. The techniques applied in this development step may be all of those familiar to the skilled person. The solvents or mixtures thereof, the aqueous solutions, and the aqueous-organic solvent mixtures may comprise auxiliaries which stabilize the formulation and/or increase the solubility of the components of the non-crosslinked regions. Examples of such auxiliaries are emulsifiers, surfactants, salts, acids, bases, stabilizers, corrosion inhibitors, and suitable combinations thereof. For development with these solutions, it is possible to use all of the techniques known to the skilled person, such as, for example, dipping, washing or spraying with the developing medium, brushing in the presence of developing medium, and suitable combinations thereof. Preference is given to developing with neutral aqueous solutions or water, with removal assisted by means of rotating brushes or a plush web. Another way of influencing the development is to control the temperature of the developing medium and to accelerate the development by raising the temperature, for example. In this step, it is also possible for further layers still present on the radiation-sensitive layer to be removed, if these layers can be detached during development and sufficiently dissolved and/or dispersed in the developer medium. Optionally one or more steps of post treatment, post exposure, and/or detackifying are performed. These include, for example, a thermal treatment, a drying, a treatment with electromagnetic rays, with plasma, with gases or with liquids, attachment of identification features, cutting to format, coating, and any desired combinations thereof. A thermal treatment may be utilized, for example, to initiate and/or to complete reactions, to increase the mechanical and/or thermal stability of the relief structure, and to remove volatile constituents. For the thermal treatment, it is possible to use the known techniques, such as heating using heated gases or liquids, IR radiation, and any desired combinations thereof, for example. In these contexts, it is possible to employ ovens, blowers, lamps, and any desired combinations thereof. In addition to disbanding, surface modifications can also be accomplished by the treatment with gases, plasma and/or liquids, especially if in addition there are reactive substances employed as well. Treatment with electromagnetic radiation may be used, for example, for the purpose of detackifying the surfaces of the relief structure, and triggering and/or completing polymerization reactions and/or crosslinking reactions. The wavelength of the irradiated electromagnetic waves in this case is in the range from 200 to 2000 nm.

### EXAMPLES

### Trial composition and preparation of relief precursors

Plates were produced with the following trial compositions:
- 10 parts by weight of hexanediol diacrylate (HDDA) as an ethylenically unsaturated compound,
- 2.0 parts by weight of benzil dimethyl ketal (BDK) as a photoinitiator;
- 21 parts by weight of a liquid polybutadiene polymer (PBP) as a plasticizer;
- 1.1 parts by weight of further constituents such as additives and dyes (A);
- 59 to 66 parts by weight of a binder (B), an SBS triblock copolymer that had a styrene content of about 28.5% and a diblock fraction of around 17%, (hence SBS-rubber based), and
- 0 to 6.5 parts by weight of stabilizers (S).

In the given examples, the amount of stabilizer was varied in the range of 0 to 6.5 parts by weight and the excess was counterbalanced by the amount of binder, respectively.

The components were dissolved in a solvent, being toluene (also called methylbenzene) and heated under reflux to obtain a homogeneous solution (concentration in toluene: 45 wt.%).

The solution was then cast on a carrier sheet. The plate thickness was adjusted using a doctor blade with a gap of 3 mm distance to the carrier sheet (PET film with 175 µm thickness).

The solvent was allowed to evaporate at room temperature for 16 hours followed by heating at 65 °C for 4 hours. To allow digital imaging, a mask layer (ML) coated on a cover sheet (CL) was laminated on top of the relief precursor using an Excelam-Q laminator (GMP Deutschland GmbH, Germany). Lamination was carried out at a temperature of the heated roll of 110 °C, a velocity of 8.8 mm/s, and at a gap of 1.5 mm. To finish the lamination, the cast plate was sandwiched between two aluminum plates and was kept at 65 °C for 3 h.

### Evaluating the samples

### Thermal melt stability

The thermal melt stability was assessed by recording the melt viscosity during heating.

Crosslinking of the sample was recorded as an increase in viscosity. Oscillatory rheological measurements were carried out using a Kinexus lab+ rheometer (Malvern Instruments Ltd., UK) under isothermal (T = 160 °C) conditions. Data was recorded using the corresponding software rSPACE version 1.76 (Malvern Instruments Ltd., UK). As measurement geometry, parallel plates with a diameter of 2.5 cm of the upper plate were chosen. As sample, a disc of a relief precursor with a diameter of 2.5 cm was used. Prior to measurement, any foils (e.g. the cover sheet) and mask layers were removed from the relief precursor. Measurements were carried out in oscillation single frequency mode. The frequency was set to 1 Hz. The gap between the parallel plates was set constant to the respective sample thickness. Data points were recorded every 15 s. The complex shear viscosity η* was monitored over time t. The "onset time of crosslinking" was identified as "the time when the difference quotient Δη* / Δt is ≥ 1 Pa, with Δt = 15 s". A higher onset time indicates a higher thermal stability and stability towards mechanical stress.

### Printing plate evaluation

To obtain a cliché, the laser ablatable mask on the front side was imaged using a TfxX 20 laser (Flint Group Germany GmbH, Germany, rotational speed: 10 to 11 rounds/s, power: 35 W (100% intensity)). The relief precursor was exposed to UV light from the backside through the carrier foil for 20 to 40 s and from the front side through the mask layer for 15 min. During the exposure at room temperature (being around 18 - 25°C), no active heating was present. As a result of the crosslinking reaction due to the exposure, the temperature of the plate rose to around 40 °C (machine type: Combi FIII (Flint Group Germany GmbH, Germany), UVA intensity mW/cm², UVA tube type: Philips TL 80W/10-R). Non-polymerized material and residual black mask layer were removed using a nyloflex^{®} Digital Washer FIII (Flint Group Germany GmbH, Germany) and nylosolv^{®} A (Flint Group Germany GmbH, Germany) as washout solvent at a solvent temperature of 35 °C, a washout speed of 230 to 240 mm/min, and a brush height of 0 mm. After washout, the plates were dried at 60 °C for 2 h (Combi FIII (Flint Group Germany GmbH, Germany)). Post-curing was performed using UVA and UVC from the front side (machine type: Combi FIII (Flint Group Germany GmbH, Germany)), UVA exposure time: 10 min, UVA intensity: 11 mW/cm², UVA tube type: Philips TL 60W/10-R, UVC exposure time: 5 min, UVC intensity: 13 mW/cm², UVC tube type Philips TUV 75W HO G75 T8, UVA and UVC post-exposure were started simultaneously).

### Example 1

The trial composition as mentioned above was used. In this example, the samples each had a certain type and/or concentration of stabilizer. As a reference stabilizer butylhydroxytoluene (BHT), also known as 2,6-di-tert-butyl-4-methylphenol was used. Its exemplary structure is shown below.

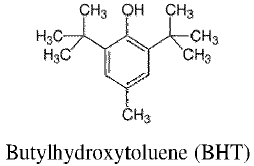

As an inventive stabilizer, the vitamin derivative ascorbyl palmitate (AP) was used. This vitamin derivative can be seen as a fatty acid ester of ascorbic acid and palmitic acid, exemplary structures are shown below.

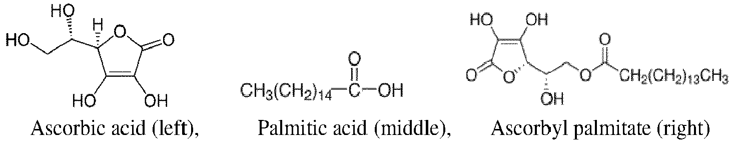

It is believed that the carbon chain, being the -(CH₂)₁₄CH₃ chain improves the compatibility of the vitamin derivative in the SBS rubber. Moreover, the surfactant like structure of the vitamin derivative might result in an improved stabilization towards oxygen at interfaces.

Table 1 shows the respective type of stabilizer, the concentration in wt.% and in mol equivalents as well as the resulting onsite time of crosslinking. For the onset time of crosslinking t, a mean value out of two measurements was used.

**Table 1: Different stabilizers in an SBS-rubber based formulation and their effect on the onset time of crosslinking.**

| **Sample** | **Stabilizer type** | **Stabilizer concentration** | | **Onset time *t* (Δ*η** / Δ*t* ≥ 1 Pa) / min** |
|---|---|---|---|---|
| | | **(wt.%)** | **(mol equivalents)** | |
| 1.1 | No additional stabilizer | 0.0 | 0.0 | 6 |
| 1.2 | Ascorbic acid | Not soluble | | |
| 1.3 | BHT | 0.5 | 1.0 | 24 |
| 1.4 | Ascorbyl palmitate | 1.0 | 1.0 | 34 |

It was found that the stabilizer ascorbyl palmitate (AP) had a higher onset time of crosslinking than an equimolar amount of tert-butylhydroxytoluene (also referred to as BHT) (Table 1) which indicates a better stabilization as it takes longer before viscosity increased due to addition and crosslinking reactions. The reference ascorbic acid was not compatible with the trial formulation and could hence not be tested.

### Example 2

The trial composition as mentioned above was used. In this example, ascorbyl palmitate was tested as stabilizer in different concentrations and compared to a plate comprising no additional stabilizer.

**Table 2: Different concentrations of ascorbyl palmitate as stabilizer in an SBS-rubber based formulation and its effect on the onset time of crosslinking.**

| **Sample** | **Stabilizer type** | **Stabilizer concentration** | | **Onset time *t* (Δ*η** / Δ*t* ≥ 1 Pa) / min** |
|---|---|---|---|---|
| | | **(wt.%)** | **(mol equivalents)** | |
| 2.1 | No additional stabilizer | 0.0 | 0.0 | 6 |
| 2.2 | Ascorbyl palmitate | 0.1 | 0.1 | 6 |
| 2.3 | Ascorbyl palmitate | 0.5 | 0.5 | 25 |
| 2.4 | Ascorbyl palmitate | 1.0 | 1.0 | 34 |
| 2.5 | Ascorbyl palmitate | 2.0 | 2.0 | 67 |
| 2.6 | Ascorbyl palmitate | 5.0 | 3.0 | >90 |

With increasing amount of stabilizer, the onset time of crosslinking increased, indicating a higher thermal stability (Table 2). Preferably, the stabilizer concentration is 0.1 wt.% or more, more preferably 0.3 wt% or more, even more preferably 0.8 wt% or more and still even more preferably 1 wt% or more.

### Example 3A

The trial composition as mentioned above was used. In this example, different stabilizer types and/or stabilizer concentrations and/or different combinations of stabilizers were tested.

**Table 3A: Testing the SBS-rubber based formulation with or without the 1 wt.% ascorbyl palmitate (AP) stabilizer in combination with other types of stabilizers. The onset time of crosslinking was derived as the mean value of two measurements, respectively.**

| **Sample** | **Stabilizer class** | **Stabilizer type and/or stabilizer combinations** | **Total stabilizer concentration** | | **Onset time t (Δ*η** / Δ*t* ≥ 1 Pa) / min** |
|---|---|---|---|---|---|
| | | | **(wt.%)** | **(mol equivalents)** | |
| 3.1 | No additional stabilizer | | 0.0 | 0.0 | 6 |
| 3.2 | Vitamin derivative | AP | 1.0 | 1.0 | 34 |
| 3.3 | | AP | 2.0 | 2.0 | 67 |
| 3.4 | Phenolic | BHT | 0.5 | 1.0 | 24 |
| 3.5 | | BHT | 1.0 | 2.0 | 39 |
| 3.6 | Combination | BHT + AP (Combination) | 0.5 + 1.0 | 2.0 | 79 |

In combination with other stabilizer classes, a synergistic effect between ascorbyl palmitate and the tested stabilizers was observed. The onset time of crosslinking obtained for the stabilizer combination exceeded the onset time of crosslinking obtained for an equimolar amount of the single stabilizers alone. See for example sample 3.6 achieving an improved thermal stabilization (79 min) over samples 3.3 (67 min) and 3.5 (39 min) (Table 3A).

### Example 3B

The trial composition as mentioned above was used. In this example, additional samples were tested with further other stabilizer classes (e.g. phenolic acrylate type, tertiary amine acrylate etc.) in formulations with or without the AP stabilizer. A synergistic effect was found when the vitamin derivative (S1) was combined with other stabilizers (S2). Hence, in some embodiments, it is preferred to have a first stabilizer being a vitamin or vitamin derivative and a second (additional) stabilizer. Exemplary second stabilizers are shown in Table 3Ba.

**Table 3Ba: Further stabilizers (other than the vitamins and vitamin derivatives.**

| **Stabilizer (S2) class** | **Stabilizer (S2) and chemical structure** |
|---|---|
| Phenolic + acrylate | 2-tert-Butyl-6-(3-tert-butyl-2-hydroxy-5-methylbenzyl)-4-methylphenyl acrylate |
| | 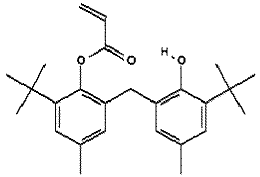 |
| Phenolic | Pentaerythritol tetrakis(3-(3,5-di-tert-butyl-4-hydroxyphenyl)propionate) |
| | 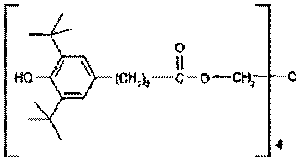 |
| Phosphite | Tris(2,4-di-tert-butylphenyl) phosphite |
| | 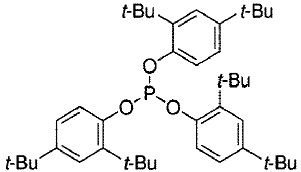 |
| Thioether | Didodecyl ',3'-thiodipropionate |
| | 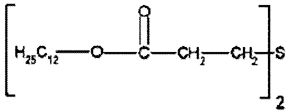 |
| Hindered amine | 1,5,8,12-Tetrakis[4,6-bis(N-butyl-N-1,2,2,6,6-pentamethyl-4-piperidylamino)-1,3,5-triazin-2-yl]-1,5,8,12-tetraazadodecane |
| | 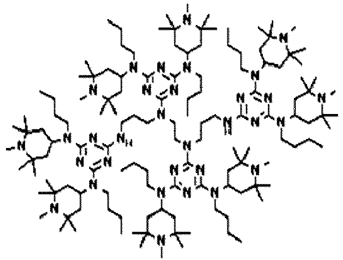 |
| Phenolic + amine | 2',3-Bis[[3-[3,5-di-tert-butyl-4-hydroxyphenyl]propionyl]]propionohydrazide |
| | 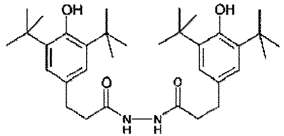 |
| Amine | Bis [4-(2-phenyl-2-propyl)phenyl] amine |
| | 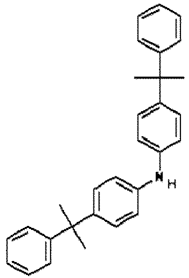 |
| Thioether amine | 2,6-Di-tert-butyl-4-(4,6-bis(octylthio)-1,3,5-triazin-2-ylamino)phenol |
| | 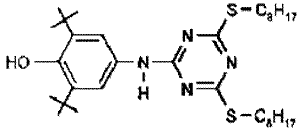 |
| Tertiary amine + acrylate | 1H-Azepine-1-propanoic acid, hexahydro-, 2,2-bis[[(1-oxo-2-propen-1-yl)oxy]methyl]butyl ester or 2,2-Bis[[(1-oxo-2-propen-1-yl)oxy]methyl]butyl hexahydro-1H-azepine-1-propanoate |

The onset times of crosslinking for the combinations comprising both a first stabilizer (S1) and second stabilizer (S2) are listed in Table 3Bb.

**Table 3Bb: Testing the formulation with other types of stabilizers in combination with or without 1 wt.% ascorbyl palmitate (AP) as stabilizer. *Polymerized during sample preparation **Slight increase over time (6%). In combination with AP, no increase. With other types of stabilizers, a synergistic effect was observed, when combined with the AP stabilizer (Table 3Bb). The onset time of crosslinking was found to be far higher for the combinations than for the plates stabilized with only one type of stabilizer.**

| **Sample** | **Stabilize r class** | **Stabilizer type and/or stabilizer combinations.** | **Total stabilizer concentration** | | **Onset time t (Δ*η** / Δ*t* ≥ 1 Pa) / min** |
|---|---|---|---|---|---|
| | | **E.g. with or without the AP stabilizer** | **(wt.%)** | **(mol equivalents)** | |
| 3.7 | No additional stabilizer | | 0.0 | 0.0 | 6 |
| 3.8 | Vitamin derivative | AP | 1.0 | 1.0 | 34 |
| 3.9 | | AP | 2.0 | 2.0 | 67 |
| 3.10 | Phenolic + acrylate | 2-tert-Butyl-6-(3-tert-butyl-2-hydroxy-5-methylbenzyl)-4-methylphenyl acrylate | 1.0 | 1.0 | 7 |
| 3.11 | | 2-tert-Butyl-6-(3-tert-butyl-2-hydroxy-5-methylbenzyl)-4-methylphenyl acrylate + AP (Combination) | 1.0 + 1.0 | 2.0 | >90 |
| 3.12 | Phenolic | Pentaerythritol tetrakis(3-(3,5-di-tert-butyl-4-hydroxyphenyl)propionate) | 2.8 | 1.0 | 6 |
| 3.13 | | Pentaerythritol tetrakis(3-(3,5-di-tert-butyl-4-hydroxyphenyl)propionate) + AP (Combination) | 2.8 + 1.0 | 2.0 | >90 |
| 3.14 | Phosphite | Tris(2,4-di-tert-butylphenyl) phosphite | 1.6 | 1.0 | 43 |
| 3.15 | | Tris(2,4-di-tert-butylphenyl) phosphite + AP (Combination) | 1.6 + 1.0 | 2.0 | >90 |
| 3.16 | Thioether | Didodecyl ',3'-thiodipropionate | 1.2 | 1.0 | 5 |
| 3.17 | | Didodecyl ',3'-thiodipropionate + AP (Combination) | 1.2 + 1.0 | 2.0 | >90 |
| 3.18 | Hindered amine | 1,5,8,12-Tetrakis[4,6-bis(N-butyl-N-1,2,2,6,6-pentamethyl-4-piperidylamino)-1,3,5-triazin-2-yl]-1,5,8,12-tetraazadodecane | 5.5 | 1.0 | 6 |
| 3.19 | | 1,5,8,12-Tetrakis[4,6-bis(N-butyl-N-1,2,2,6,6-pentamethyl-4-piperidylamino)-1,3,5-triazin-2-yl]-1,5,8,12-tetraazadodecane + AP (Combination) | 5.5 + 1.0 | 2.0 | >90 |
| 3.20 | Phenolic + amine | 2',3-Bis[[3-[3,5-di-tert-butyl-4-hydroxyphenyl]propionyl]]propiono-hydrazide | 1.3 | 1.0 | 0* |
| 3.21 | | 2',3-Bis[[3-[3,5-di-tert-butyl-4-hydroxyphenyl]propionyl]]propiono-hydrazide + AP (Combination) | 1.3 + 1.0 | 2.0 | >90 |
| 3.22 | Amine | Bis [4-(2-phenyl-2-propyl)phenyl] amine | 1.0 | 1.0 | 10 |
| 3.23 | | Bis [4-(2-phenyl-2-propyl)phenyl] amine + AP (Combination) | 1.0 + 1.0 | 2.0 | >90 |
| 3.24 | Thioether amine phenol | 2,6-Di-tert-butyl-4-(4,6-bis(octylthio)-1,3,5-triazin-2-ylamino)phenol | 1.4 | 1.0 | >90** |
| 3.25 | | 2,6-Di-tert-butyl-4-(4,6-bis(octylthio)-1,3,5-triazin-2-ylamino)phenol + AP (Combination) | 1.4 + 1.0 | 2.0 | >90 |
| 3.26 | Tertiary amine + acrylate | 1H-Azepine-1-propanoic acid, hexahydro-, 2,2-bis[[(1-oxo-2-propen-1-yl)oxy]methyl]butyl ester or 2,2-Bis[[(1-oxo-2-propen-1-yl)oxy]methyl]butyl hexahydro-1H-azepine-1-propanoate | 1.0 | 1.0 | 30 |
| 3.27 | | 1H-Azepine-1-propanoic acid, hexahydro-, 2,2-bis[[(1-oxo-2-propen-1- | 1.0 + 1.0 | 2.0 | 75 |
| | | yl)oxy]methyl]butyl ester or 2,2-Bis[[(1-oxo-2-propen-1-yl)oxy]methyl]butyl hexahydro-1H-azepine-1-propanoate + AP (Combination) | | | |

### Example 4

In this example, the effect of the stabilizer on the tonal values of the resulting printing plates was assessed since conventional stabilizers can impact tonal values as they may hinder curing. The trial composition as mentioned above was used for the samples with BHT and AP as stabilizers. The example shows that the AP stabilizer has far less impact on the tonal value. The stabilizer impact on the tonal value was calculated as the difference of the tonal value of the 5% halftone at 146 lpi of a plate without any additional stabilizer compared to the respective tonal value of a plate comprising a stabilizer.

**Table 4: Minimum halftone at 146 lines per inch (lpi) of an SBS-rubber based sample formulations, said samples having no stabilizer, a BHT stabilizer as a reference and an inventive AP stabilizer.**

| **Sample** | **Stabilizer type** | **Stabilizer concentration** | | **Min. halftone (at 146 lpi)** | **Tonal value of 5% halftone (at 146 lpi)** | **Stabilizer impact on tonal value** |
|---|---|---|---|---|---|---|
| | | **(wt.%)** | **(mol equivale nts)** | | | |
| 4.1 | No additional stabilizer | | 0.0 | 1.2% | 3.7% | / |
| 4.2 | Ascorbic acid | Not soluble | | | | / |
| 4.3 | Butylated hydroxytoluene (BHT) | 0.5 | 1.0 | 5.0% | 0.7% | 3% |
| 4.4 | Ascorbyl palmitate (AP) | 1.0 | 1.0 | 1.8% | 2.9% | 0.8% (good) |

The BHT hindered the crosslinking during UV exposure. Consequently, no halftone dots smaller than the 5% tonal value were anchored on the relief. The BHT also reduced the resulting dot size. The 5% halftone resulted in a tonal value of 0.7% on the cliché, only.

Without additional stabilizer, far smaller dots than with BHT can be reproduced on the cliché, starting from a halftone of 1.2%, resulting in a tonal value of 3.7% on the cliché. Nevertheless, without additional stabilizer, the melt (already) undergoes crosslinking upon heating, e.g. during production of the relief precursor. The reference ascorbic acid was not compatible with the trial formulation and could hence not be tested.

With the inventive stabilizer ascorbyl palmitate, an improved thermal stability of the melt was achieved (see Table 1). At the same time, the copy properties were only affected to a minor degree (only 0.8%) (Table 4). The addition of 1 wt.% ascorbyl palmitate to the plate formulation resulted in a minor increase in the first stable halftone at 146 lpi from 1.2% to 1.8%, and in a minor decrease in the resulting dot size (tonal value decreased from 3.7% to 2.9%). The effect of ascorbyl palmitate on the copy properties was far lower than for an equimolar amount of the reference BHT (Table 4).

Hence, it is shown that the AP performance supersedes the performance of the BHT stabilizer. Also, due to the improved thermal stability caused by the ascorbyl palmitate stabilizer, one can avoid unintended gel formation caused by mechanical and thermal stress, e.g. due to the kneading during extrusion of the rubber like mixtures to form the relief precursors.

### Example 5

In this example, another trial formulation based on a SIS tri-block copolymer was used. The materials in plate form were produced according to the above mentioned method with the following composition:
- 10 parts by weight of hexanediol diacrylate (HDDA),
- 2.0 parts by weight of benzil dimethyl ketal as photoinitiator (BDK),
- 5 parts by weight of a hydrocarbon resin (CAS 9017-27-0),
- 1.1 parts by weight of further constituents such as additives and dyes (A),
- 81 to 82 parts by weight of a binder (B), an SIS triblock copolymer with a styrene content of around 15% and a diblock fraction of around 19%, and
- 0 to 1 parts by weight of stabilizers (S).

In the given examples, the amount of stabilizer was varied in the range of 0 to 1 parts by weight and the excess was counterbalanced by the amount of binder, respectively.

**Table 5: An SIS-rubber based formulation with ascorbyl palmitate compared to a formulation without any additional stabilizer, and compared to a formulation with an equimolar amount of BHT as reference and the respective onset time of crosslinking.**

| **Sample** | **Stabilizer type** | **Stabilizer concentration** | | **Onset time t (Δ*η** / Δ*t* ≥ 1 Pa) / min** |
|---|---|---|---|---|
| | | **(wt. %)** | **(mol equivalents)** | |
| 5.1 | No additional stabilizer | 0.0 | 0.0 | 5 |
| 5.2 | Ascorbic acid | Not soluble | | |
| 5.3 | Butylated hydroxytoluene (BHT) | 0.5 | 1.0 | 16 |
| 5.4 | Ascorbyl palmitate (AP) | 1.0 | 1.0 | >90 |

Without additional stabilizer, crosslinking was observed after 5 min of measurement time. The reference ascorbic acid was not compatible with the trial formulation and could hence not be tested. With BHT, the onset time of crosslinking was increased from 5 to 16 min. The effect of ascorbyl palmitate (AP) on the onset time on crosslinking is more than five times as high as for an equimolar amount of BHT indicating a higher thermal stability and better producibility within an extrusion process (Table 5).

### Example 6

In this example, the type of the plasticizers and the type and concentration of stabilizers were varied. The materials in plate form were produced according to the above mentioned method with the following trial composition:
- 10 parts by weight of hexanediol diacrylate (HDDA) as an ethylenically unsaturated compound,
- 2 parts by weight of benzil dimethyl ketal (BDK) as a photoinitiator;
- 21 parts by weight of a liquid plasticizer, namely a polybutadiene or a bio-based plasticizer;
- 1 part by weight of further constituents such as additives and dyes (A);
- 64 to 66 parts by weight of a binder (B), an SBS triblock copolymer that had a styrene content of about 25% and a diblock fraction of around 10%, (hence SBS-rubber based), and
- 0 to 1.5 parts by weight of stabilizers (S).

In the given example, the amount of stabilizer was varied in the range of 0 to 1.5 parts by weight and the excess was counterbalanced by the amount of binder, respectively. The type of stabilizer and the type of plasticizer were varied. The rheology measurement time was 30 min, respectively.

**Table 6: Testing the SBS-rubber based formulation with different types of stabilizers in combination with different types of plasticizers.**

| **Sample** | **Stabilizer** | **Stabilizer concentration** | | **Plasticizer** | **Onset time *t* (Δ*η** / Δ*t* ≥ 1 Pa) / min** |
|---|---|---|---|---|---|
| | | **(wt.%)** | **(mol equivalents)** | | |
| 6.1 | No additional stabilizer | 0.0 | 0.0 | Polybutadiene | 6 |
| 6.2 | Butylated hydroxytoluene (BHT) | 1.5 | 2.8 | Polybutadiene | >30 |
| 6.3 | Ascorbic acid | Not soluble | | Polybutadiene | / |
| 6.4 | Tocopherol | 1.5 | 1.4 | Polybutadiene | 29 |
| 6.5 | Ascorbyl palmitate (AP) | 1.5 | 1.5 | Polybutadiene | >30 |
| 6.6 | No additional stabilizer | 0.0 | 0.0 | Linseed oil | 13 |
| 6.7 | Tocopherol | 1.5 | 1.4 | Linseed oil | >30 |
| 6.8 | Ascorbyl palmitate (AP) | 1.5 | 1.5 | Rapeseed oil | >30 |
| 6.9 | Tocopherol | 1.5 | 1.4 | Rapeseed oil | >30 |

The reference ascorbic acid was not compatible with the trial formulation and could hence not be tested. Compared to sample 6.1 without any additional stabilizer, the onset time of crosslinking was found to be increased for the inventive stabilizers ascorbyl palmitate and tocopherol also in presence of different types of liquid plasticizers, such as polybutadiene or bio-based plasticizers (Table 6).

### Example 7

Kneading trials were carried out using a ThermoFisher Scientifc Haake kneading device equipped with a Haake PolyLab OS RheoDrive 7 control unit, a Haake Rheomix 600 OS heating and kneading chamber with Roller Rotors R600. The torque and the sample temperature were recorded using the software PolySoft, version 2.1.0.1. For the measurement, a temperature of 180 °C was applied. The measurement was carried out for 60 min, respectively. The components were added to the kneading device as solids and were allowed to be mixed in the kneading device.

As a sample, 50 g of the following composition was used:
- 99 to 100 parts by weight of a binder (B), an SBS triblock copolymer that had a styrene content of about 25% and a di-block fraction of around 10%, (hence SBS-rubber based), and
- 0 to 1.0 parts by weight of stabilizers (S).

In the given sample, the amount of stabilizer was varied in the range of 0 to 1.0 parts by weight and the excess was counterbalanced by the amount of binder, respectively.

**Table 7: Testing the SBS-rubber based formulation with different types of stabilizers in kneading trials.**

| **Sample** | **Stabilizer type** | **Stabilizer concentration** | | **Onset time *t*/ min** |
|---|---|---|---|---|
| | | **(wt. %)** | **(mol equivalents)** | |
| 7.1 | No additional stabilizer | 0.0 | 0.0 | 10 |
| 7.2 | Butylated hydroxytoluene (BHT) | 0.53 | 1.0 | 28 |
| 7.3 | Ascorbic acid | Not soluble | | |
| 7.4 | Ascorbyl palmitate (AP) | 1.0 | 1.0 | 50 |

An increase in torque indicated the onset of crosslinking of the SBS-rubber due to insufficient stabilization. Without additional stabilizer, an increase in torque was observed within the first 10 min of measurement time. With BHT as stabilizer, an increase in torque was detected after 28 min of heating at 180 °C. With ascorbyl palmitate, the best result was achieved, where crosslinking was observed after 50 min. The reference ascorbic acid was not compatible with the trial formulation and could hence not be tested.

### Example 8

The trial composition as mentioned in example 1 was used. The printing plate precursor was developed according to the procedure described in the section printing plate evaluation. To evaluate resistance towards UV light and cracking, afterwards, the developed printing plate was further irradiated (machine type: Combi FIII (Flint Group Germany GmbH, Germany), UVA exposure time: 40 min, UVA intensity: 11 mW/cm², UVA tube type: Philips TL 60W/10-R, UVC exposure time: 40 min, UVC intensity: 13 mW/cm², UVC tube type Philips TUV 75W HO G75 T8, UVA and UVC post-exposure were started simultaneously). On a 5 x 8 cm piece of a solid printing area, the edge of the middle of the long side was cut with a knife (0.2 mm). The plate piece was bent in a 180 ° angle in a way that the cut was able to propagate along the relief layer (carrier foil on carrier foil). After 5 minutes, the total length of cracked relief layer along the bend was measured subtracting the initial cut length. Cracks not following the original cut (e.g. staring in the middle of the bent due to brittleness) were also considered.

**Table 8: Tear testing of BHT and AP stabilizer**

| **Sample** | **Stabilizer type** | **Stabilizer concentration** | | **tearing [cm]** |
|---|---|---|---|---|
| | | **(wt.% )** | **(mol equivalents)** | |
| 8.1 | No additional stabilizer | 0.0 | 0.0 | 2.1 |
| 8.2 | Butylated hydroxytoluene (BHT) | 0.5 | 1.0 | 0.5 |
| 8.3 | Ascorbyl palmitate (AP) | 1.0 | 1.0 | 0.0 |

A longer tear indicates less stability after prolonged UV exposure. With ascorbyl palmitate, the best result without tearing was achieved. With equimolar mounts of BHT, tearing was more pronounced. Without additional stabilizer, the longest tear was observed.

### Example 9

Several carbamate derivatives from ascorbic acid (AAD) were synthesized and used in a similar trial composition as mentioned earlier in example 1. Reaction mixtures were used completely without purification and were simply added to the plate formulation during homogenization in toluene solution. The stoichiometric amount of the reactants was calculated in a way to obtain a concentration of 1 wt% carbamate derivative in the plate formulation, assuming full conversion of the reactants. For each synthesis of the entries in Table 9 below, 1.0 molar equivalent (eq.) Ascorbic Acid (AA), 2.0 molar equivalents isocyanate (IC) and 0.05 molar equivalents catalyst (Di-n-butyl tin dilaurate) were suspended in THF (concentration: 35 wt% reactants, 65% wt% solvent) and heated to 60 °C for 5 hours. The reaction was quenched with an excess ethanol (same volume as the reaction mixture) and added to the plate formulation in toluene solution. The procedure for production of the plate precursor was followed as mentioned above. The solution was cast on a carrier sheet and traces of THF/ethanol were evaporated together with toluene during the drying step of the plate precursor.

For the reference (Ref.) in Table 9 below, the same procedure was followed, however, without the addition of an AAD .

Detailed procedure on the example of entry 1: 1.84 g n-Butyl isocyanate (0.0186 mol, 2 eq.), 1.61 g L-Ascorbic Acid (0.0093 mol, 1 eq.) and 0.294 g Di-n-butyl tin dilaurate (0.000465 mol, 0.05 eq.) were suspended in 7 g THF and stirred for 5 hours at 60 °C. The reaction progress was monitored by thin layer chromatography (silica gel 60 F254, Aldrich, solvent: Dichloromethane : Ethanol 3 : 1, Rf (retention factor, ascorbic acid) = 0.02), Rf (product) = 0.70). Compounds were visualized on the TLC plate by staining with Seebach-solution (mixture of phosphomolybdic acid hydrate, cerium(IV)sulphate, sulfuric acid and water). To quench the reaction, 10 mL Ethanol were added to the mixture.

**Table 9: Testing of carbamate derivatives**

| Entry | Isocyanate used (IC) to obtain ascorbic acid derivative (AAD) | Chemical structure | (OT) | OWc (MF) | MW (MF) | OWc (BF) | MW (BF) | Type of isocyanate |
|---|---|---|---|---|---|---|---|---|
| Ref. | None | No stabilizer was used. | 3 | / | / | / | / | / |
| 1 | n-Butyl isocyanate | CH₃CH₂CH₂CH₂NCO | 74 | 0.18 | 275.26 | 2.24 | 374.39 | an alkyl isocyanate |
| 2 | p-Toluenesulfonyl isocyanate | 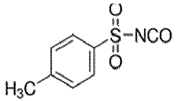 | 5 | 0.26 | 373.34 | 2.41 | 570.55 | a sulfonyl isocyanate |
| 3 | Phenyl isocyanate | 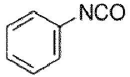 | 51 | 0.5 | 295.25 | 2.89 | 414.37 | an aryl isocyanate |
| 4 | (Triethoxysilyl)-propylisocyanat | 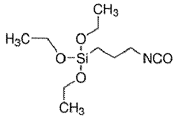 | 20 | -0.34 | 423.50 | 1.2 | 670.86 | an alkoxy silyl alkyl isocyanate |
| 5 | t-Butyl isocyanate | 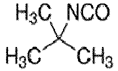 | 34 | 0.07 | 275.26 | 2.02 | 374.39 | an alkyl isocyanate |
| 6 | 2-Isocyanatoethyl Methacrylate | 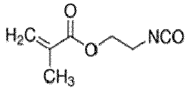 | 33 | -0.36 | 331.28 | 1.16 | 486.44 | an methacrylic alkyl isocyanate |
| 7 | α,α-Dimethyl-3-isopropenyl-benzylisocyanat | 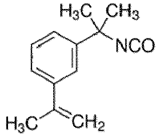 | 24 | 2.19 | 363.37 | 6.26 | 550.61 | an methacrylic aryl alkyl isocyanate |
| 8 | Cyclohexyl isocyanate | 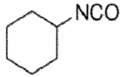 | 52 | 0.98 | 301.30 | 3.84 | 426.47 | a cycloalkyl isocyanate |
| 9 | Trimethylsilyl isocyanate | 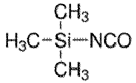 | 5 | 0.10 | 291.33 | 2.09 | 406.54 | an alkyl silyl isocyanate |
| 10 | Octadecyl isocyanate | 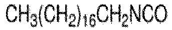 | 6 | 7.06 | 471.64 | 15.9 9 | 767.15 | an alkyl isocyanate |
| 11 | 4-Isopropylphenyl isocyanate | 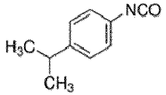 | 55 | 1.96 | 337.33 | 5.8 | 498.54 | an alkyl aryl isocyanate |
| Entry | Isocyanate used (IC) to obtain ascorbic acid derivative (AAD) | Chemical structure | (OT) | OWc (MF) | MW (MF) | OWc (BF) | MW (BF) | Type of isocyanate |
| 12 | m-tolyl isocyanate | 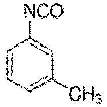 | 33 | 1.05 | 309.28 | 3.98 | 442.43 | an alkyl aryl isocyanate |
| 13 | 2-phenylethylisoc yanate | 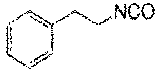 | 6 | 0.91 | 323.30 | 3.69 | 470.48 | an aryl alkyl isocyanate |
| 14 | Dodecyl isocyanate | 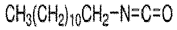 | 44 | 3.97 | 385.46 | 9.83 | 594.80 | an alkyl isocyanate |
| 15 | 1-Naphthylisocyan ate | 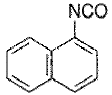 | 4 | 1.68 | 345.31 | 5.24 | 514.50 | an aryl isocyanate |
| 16 | 2-(2-Isocyanatoethox y) ethyl methacrylate | 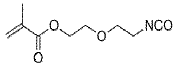 | Nd* | -0.63 | 375.34 | 0.61 | 574.54 | a methacrylic ethylene glycol isocyanate |
| 17 | 1,1-Bis(acryloyloxy methyl) ethyl isocyanate | 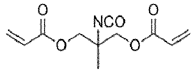 | 6 | 0.46 | 415.36 | 2.80 | 654.59 | a bifunctional acrylic isocyanate |

Molecular weight (MW) (g/mol) of the monofunctional (MF) and bifunctional derivative (BF). Different isomers are possible. The calculated octanol-water coefficient (OWc) is the same for possible monofunctionalized carbamate isomers. *Not determined (nd). Onset time t (Δη* / Δt ≥ 1 Pa) / min (OT)

Exemplary IR spectroscopy measurements of the dried, crude product:
- L-ascorbic acid (reference)
   IR (ATR): 3524.1, 3406.3, 3308.8, 3001.5, 2915.8, 2713.2, 1752.3, 1652.5, 1497.2, 1456.3, 1387.6, 1363.0, 1312.8, 1271.3, 1246.8, 1220.9, 1197.0, 1111.1, 1075.3, 1043.7, 1022.6, 987.9, 869.3, 819.7, 753.7, 720.0, 679.7 cm⁻¹.
- Entry 1 - 1-(3,4-dihydroxy-5-oxo-2,5-dihydrofuran-2-yl)ethane-1,2-diyl bis(butylcarbamate) IR (ATR): nd.
- Entry 2 - 1-(3,4-dihydroxy-5-oxo-2,5-dihydrofuran-2-yl)ethane-1,2-diyl bis(tosylcarbamate) IR (ATR): nd.
- Entry 3 - 1-(3,4-dihydroxy-5-oxo-2,5-dihydrofuran-2-yl)ethane-1,2-diyl bis(phenylcarbamate)
   IR (ATR): 3305.8, 3138.7, 3062.4, 2979.8, 1703.5, 1598.6, 1537.6, 1500.3, 1444.3, 1408.8, 1312.9, 1212.8, 1119.1, 1082.8, 1061.0, 1029.4, 897.6, 826.7, 751.3, 690.3 cm⁻¹.
- Entry 4 - 1-(3,4-dihydroxy-5-oxo-2,5-dihydrofuran-2-yl)ethane-1,2-diyl bis((3-(triethoxysilyl)propyl)carbamate)
   IR (ATR): nd.
- Entry 5 - 1-(3,4-dihydroxy-5-oxo-2,5-dihydrofuran-2-yl)ethane-1,2-diyl bis(tert-butylcarbamate) IR (ATR): nd.
- Entry 6 - 6-(3,4-dihydroxy-5-oxo-2,5-dihydrofuran-2-yl)-4,9-dioxo-5,8-dioxa-3,10-diazadodecane-1,12-diyl bis(2-methylacrylate)
   IR (ATR): 3352.2, 2958.5, 2359.1, 1704.1, 1634.9, 1538.3, 1452.4, 1404.0, 1319.7, 1296.1, 1252.8, 1154.3, 1039.2, 943.3, 814.1, 763.8 cm⁻¹.
- Entry 7 - 1-(3,4-dihydroxy-5-oxo-2,5-dihydrofuran-2-yl)ethane-1,2-diyl bis((2-(4-vinylphenyl)propan-2-yl)carbamate) IR (ATR): nd.
- Entry 8 - 1-(3,4-dihydroxy-5-oxo-2,5-dihydrofuran-2-yl)ethane-1,2-diyl bis(cyclohexylcarbamate) IR (ATR): 3320.8, 2930.2, 2853.8, 1771.1, 1530.2, 1449.2, 1313.1, 1277.0, 1250.4, 1230.6, 1141.7, 1081.1, 1044.6, 967.8, 891.2, 844.7, 827.1, 775.6, 759.0 cm⁻¹.
- Entry 9 - 1-(3,4-dihydroxy-5-oxo-2,5-dihydrofuran-2-yl)ethane-1,2-diyl bis((trimethylsilyl)carbamate) IR (ATR): nd.
- Entry 10 - 1-(3,4-dihydroxy-5-oxo-2,5-dihydrofuran-2-yl)ethane-1,2-diyl bis(octadecylcarbamate) IR (ATR): 3445.4, 3303.0, 2954.6, 2916.2, 2848.6, 1741.1, 1717.4, 1682.8, 1552.7, 1463.9, 1356.1, 1287.2, 1270.7, 1261.9, 1244.8, 1214.9, 1184.7, 1099.4, 1080.9, 1050.0, 968.5, 944.6, 915.9, 886.8, 854.9, 825.5, 774.7, 757.9, 719.4, 668.0 cm⁻¹.
- Entry 11 - 1-(3,4-dihydroxy-5-oxo-2,5-dihydrofuran-2-yl)ethane-1,2-diyl bis((4-isopropylphenyl)carbamate)
   IR (ATR): 3306.5, 2957.6, 2869.0, 1682.8, 1598.1, 1537.6, 1515.2, 1460.0, 1415.9, 1382.7, 1361.7, 1338.1, 1309.8, 1284.6, 1217.4, 1115.6, 1053.9, 1017.5, 890.4, 830.5, 787.7, 754.3, 722.5, 660.7 cm⁻¹.
- Entry 12 - 1-(3,4-dihydroxy-5-oxo-2,5-dihydrofuran-2-yl)ethane-1,2-diyl bis(m-tolylcarbamate) IR (ATR): 3295.4, 2916.5, 1738.1, 1634.1, 1610.8, 1597.3, 1548.8, 1488.9, 1454.2, 1405.5, 1292.8, 1263.6, 1215.9, 1167.4, 1119.9, 1043.8, 947.5, 920.7, 878.1, 778.2, 748.1, 720.7, 688.5 cm⁻¹.
- Entry 13 - 1-(3,4-dihydroxy-5-oxo-2,5-dihydrofuran-2-yl)ethane-1,2-diyl bis(phenethylcarbamate) IR (ATR): 3323.5, 3062.1, 3027.2, 2934.9, 1682.9, 1602.7, 1525.0, 1496.9, 1454.2, 1414.8, 1333.2, 1242.0, 1201.5, 1142.9, 1030.5, 748.1, 698.0 cm⁻¹.
- Entry 14 - 1-(3,4-dihydroxy-5-oxo-2,5-dihydrofuran-2-yl)ethane-1,2-diyl bis(dodec-11-en-1-ylcarbamate) IR (ATR): nd.
- Entry 15 - 1-(3,4-dihydroxy-5-oxo-2,5-dihydrofuran-2-yl)ethane-1,2-diyl bis(naphthalen-1-ylcarbamate) IR (ATR): 3278.0, 3052.6, 2971.2, 2359.1, 1744.4, 1621.6, 1598.1, 1578.4, 1540.7, 1500.6, 1466.1, 1403.2, 1345.2, 1256.8, 1214.5, 1176.1, 1109.3, 1039.7, 1013.3, 935.7, 877.6, 791.8, 769.2, 737.3, 705.5, 677.0 cm⁻¹.
- Entry 16 - 9-(3,4-dihydroxy-5-oxo-2,5-dihydrofuran-2-yl)-7,12-dioxo-3,8,11,16-tetraoxa-6,13-diazaoctadecane-1,18-diyl bis(2-methylacrylate)
   IR (ATR): nd.
- Entry 17 - 2-((8-((acryloyloxy)methyl)-3-(3,4-dihydroxy-5-oxo-2,5-dihydrofuran-2-yl)-8-methyl-6,11-dioxo-2,5,10-trioxa-7-azatridec-12-en-1-oyl)amino)-2-methylpropane-1,3-diyl diacrylate
   IR (ATR): nd.

## Claims

1. A photosensitive composition (PC) for forming a photosensitive layer of a relief precursor (RP), said composition comprising:
a radical initiator (R) such as a photoinitiator, a photoinitiator system or a thermal initiator; and
optionally an ethylenically unsaturated compound (EC);
a stabilizer (S1) for promoting extrusion stability, said stabilizer being a vitamin or a vitamin derivative; and
a binder (B), said binder being a thermoplastic elastomer block copolymer having
- a first monomeric unit (Mu1) derived from a vinyl aromatic monomer and
- a second monomeric unit (Mu2), said second monomer unit being derived from an ene-monomer and/or a diene-monomer; or combinations thereof;
wherein the stabilizer (S1) is a hydroxy tetronic acid (HTAD) derivative.

2. The composition according claim 1, wherein the stabilizer (S1)
has a predicted log octanol-water coefficient as calculated within EPI Suite v4.11 from Log Kow (WSKOW v 1.68 estimate) and wherein said predicted octanol-water coefficient (OWc) is higher than - 4, preferably higher than -2, more preferably higher than 0, even more preferably higher than 5.

3. The composition according claim 1 or 2, wherein the stabilizer (S1) has a predicted log octanol-water coefficient as calculated within EPI Suite v4.11 from Log Kow (WSKOW v 1.68 estimate) and wherein said predicted octanol-water coefficient (OWc) is in the range of - 4.0 to 12.0, more preferably in the range of -2.0 to 11.0, even more preferably in the range of 0 to 10.0, even more preferably in the range of 1.0 to 8.0, even more preferably in the range of 2.0 to 6.50.

4. The composition according to any of the previous claims, further comprising a second stabilizer (S2), said second stabilizer being chosen from one of the following classes: phenolic, phenolic and acrylate, thioether, hindered amine, phenolic and amine, amine, thioether amine, a multifunctional amine and acrylate, more preferably wherein the second stabilizer (S2) is one of:
2,6-di-tert-butyl-4-methylphenol (BHT),
2-tert-Butyl-6-(3-tert-butyl-2-hydroxy-5-methylbenzyl)-4-methylphenyl acrylate,
Pentaerythritol tetrakis(3-(3,5-di-tert-butyl-4-hydroxyphenyl)propionate), Tris(2,4-di-tert-butylphenyl) phosphite,
Didodecyl 3,3'-thiodipropionate,
1,5,8,12-Tetrakis[4,6-bis(N-butyl-N-1,2,2,6,6-pentamethyl-4-piperidylamino)-1,3,5-triazin-2- yl]-1,5,8,12-tetraazadodecane,
2',3-Bis[[3-[3,5-di-tert-butyl-4-hydroxyphenyl]propionyl]]propionohydrazide,
Bis [4-(2-phenyl-2-propyl)phenyl] amine,
2,6-Di-tert-butyl-4-(4,6-bis(octylthio)-1,3,5-triazin-2-ylamino)phenol,
a tertiary amine and acrylate,preferably 1H-Azepine-1-propanoic acid, hexahydro-, 2,2-bis[[(1-oxo-2-propen-1-yl)oxy]methyl]butyl ester or 2,2-Bis[[(1-oxo-2-propen-1-yl)oxy]methyl]butyl hexahydro-1H-azepine-1-propanoate.

5. The composition according to any one of the previous claims, wherein
the stabilizer (S1) has a molecular weight in the range of 50 - 800 g/mol, preferably 50 - 600 g/mol, more preferably 100 - 490 g/mol, even more preferably 120 - 480 g/mol, most preferably 200 - 430 g/mol; and/or wherein
the stabilizer (S1) is chosen from: Vitamin C, Vitamin E or derivatives thereof, preferably the stabilizer (S1) is a vitamin C derivative, preferably an ascorbic acid ester, even more preferably a fatty acid ester of ascorbic acid, more preferably the stabilizer (S 1) is an ascorbyl palmitate (AP); and/or wherein the stabilizer (S1) is present in a concentration of 0.1 to 10 wt.%, preferably 0.1 to 8 wt%, more preferably 0.2 to 6 wt%, even more preferably 0.5 to 2% based on the total weight of the composition.

6. The composition according to any one of the previous claims, wherein
the binder (B) has a total styrene content in the range of 3 - 50 %, preferably 8 - 38 %, more preferably 10 - 30 %, most preferably 15 - 30 %; and/or wherein
the binder (B) is chosen from a styrene-butadiene-styrene (SBS) triblock copolymer and/or a styrene-isoprene-styrene (SIS) triblock copolymer.

7. The composition according to any one of the previous claims ,
wherein the binder (B) is an styrene-butadiene-styrene (SBS) triblock copolymer
having a styrene content in the range of 8 - 48 %, preferably 13 - 43 %, more preferably 18 - 38 %; or
wherein the binder (B) is a styrene-isoprene-styrene (SIS) triblock copolymer
having a styrene content in the range of 3 - 27 %, preferably 5 - 25 %.

8. The composition according to any of the previous claims,
wherein the binder (B) is a diblock copolymer or is triblock copolymer with a diblock fraction in the range of 5 - 50%, preferably 5 - 30 %, more preferably 8 - 28 %, even more preferably 10 - 24 %.

9. The composition according to claim 1,
wherein the stabilizer (S1) is ascorbyl palmitate (AP) and the binder (B) is a styrene-butadiene (SB) diblock and/or styrene-butadiene-styrene (SBS) triblock copolymer; or
wherein the stabilizer (S1) is ascorbyl palmitate (AP) and the binder (B) is a styrene-isoprene (SI) diblock and/or styrene-isoprene-styrene (SIS) triblock copolymer.

10. The composition according to any of the previous claims, wherein the composition further comprises a plasticizer (P), said plasticizer being a bio-based plasticizer, preferably a vegetable oil, a fatty acid and/or a fatty acid ester of mono and polyfunctional alcohols; wherein said bio-based plasticizer is preferably present within the composition in an amount of at least 11 wt %, preferably at least 14 wt %, even more preferably at least 16 wt %; wherein preferably
the bio-based plasticizer is **characterized by** a UV transmission at 365 nm of a solution of 33 wt% plasticizer in n-hexane of higher than 15%, preferably higher than 25%, more preferably higher than 50%, even more preferably higher than 60%; and/or
the bio-based plasticizer is chosen from: rapeseed oil, sunflower oil, palm kernel oil, soybean oil, rapeseed oil, sunflower oil, soybean oil, palm oil, palm kernel oil, coconut oil, medium-chain triglycerides (MCT), linseed oil, safflower oil, corn oil and/or cotton seed oil, preferably rapeseed oil or sunflower oil.

11. The composition according to any of the previous claims, wherein the stabilizer is an ascorbic acid derivative (AAD).

12. A method to produce a relief precursor (RP), comprising the steps of:
- extruding the photosensitive composition according to any of the previous claims through to form an extruded photosensitive layer;
- applying the extruded layer on a dimensionally stable support (L1).

13. A relief precursor (RP) for being developed into a relief (RS) comprising:
- a dimensionally stable support (L1);
- a photosensitive layer (L2) comprising the photosensitive composition according to any one of the previous claims.

14. A relief (RS) developed from the relief precursor according to the previous claim, preferably serving as a printing sleeve or printing blanket.

15. Use of a stabilizer (S1) being a vitamin or vitamin derivative, preferably ascorbyl palmitate (AP), to improve extrusion stability of a mixture; and/or to enhance the thermal stabilization of a second stabilizer (S2) being a thermal stabilizer, preferably wherein the second stabilizer (S2) is chosen from one of the following classes: phenolic, phenolic and acrylate, thioether, hindered amine, phenolic and amine, amine, thioether amine, a multifunctional amine and acrylate, more preferably wherein the second stabilizer (S2) is butylated hydroxytoluene (BHT).
